# EUROPEAN PATENT APPLICATION

(11) **EP 4 770 387 A1**
(43) Date of publication of application: **01.07.2026**
(21) Application number: 23960480.4
(22) Date of filing: 06.12.2023
(51) Int. Cl.: H10K 59/38

(54) **LIGHT-EMITTING DEVICE AND MANUFACTURING METHOD THEREFOR, AND DISPLAY APPARATUS**

(71) Applicant: BOE TECHNOLOGY GROUP CO., LTD., Beijing 100015 (CN)
(72) Inventor: DANG, Wenhui, Beijing 100176 (CN); ZHANG, Yichi, Beijing 100176 (CN)
(74) Representative: Studio Torta S.p.A.
(86) International application number: PCT/CN2023/136624
(87) International publication number: WO 2025/118166

(57) **Abstract**

The present disclosure provides a light-emitting device, a manufacturing method thereof, and a display device. The light-emitting device includes: a substrate; a hole transport layer on the substrate; a quantum dot light-emitting layer on a side of the hole transport layer away from the substrate; and a first wavelength light absorbing molecule on a side of the hole transport layer away from the substrate. The first wavelength light absorbing molecule is configured to absorb a first wavelength light capable of causing the hole transport layer to undergo a crosslinking reaction.

## Description

### TECHNICAL FIELD

The present disclosure relates to the field of display technology, and in particular, to a light-emitting device, a manufacturing method thereof, and a display device comprising the light-emitting device.

### BACKGROUND

Light-Emitting Diode (LED) emits light by releasing energy through the recombination of electrons and holes. Light-emitting diodes comprise, but are not limited to, organic light-emitting diodes (OLED) and quantum dot light-emitting diodes (QLED). Quantum dots are semiconductor nanomaterials that can bind excitons in three dimensions. Quantum dots have great application potential in high quality displays due to their excellent characteristics such as high quantum efficiency, narrow excitation spectrum, high photostability, long fluorescence lifetime and good solution processing compatibility. Quantum dot light-emitting diode is a device using quantum dots as light-emitting materials. Compared with organic light-emitting diodes, it has outstanding advantages such as lower energy consumption, higher color purity and wider color gamut, therefore quantum dot light-emitting technology has become the most potential next-generation self-luminous display technology.

### SUMMARY

According to an aspect of the present disclosure, a light-emitting device is provided. The light-emitting device comprises: a substrate; a hole transport layer on the substrate; a quantum dot light-emitting layer on a side of the hole transport layer away from the substrate; and a first wavelength light absorbing molecule on a side of the hole transport layer away from the substrate, wherein the first wavelength light absorbing molecule is configured to absorb a first wavelength light capable of causing the hole transport layer to undergo a crosslinking reaction.

In some embodiments, the light-emitting device further comprises a first wavelength light blocking layer, wherein the first wavelength light blocking layer is between the hole transport layer and the quantum dot light-emitting layer or on a side of the quantum dot light-emitting layer away from the hole transport layer, and the first wavelength light blocking layer comprises the first wavelength light absorbing molecule.

In some embodiments, the first wavelength light blocking layer comprises an azide group or a benzophenone group.

In some embodiments, the first wavelength light absorbing molecule comprises a monoazide group or a bisazide group.

In some embodiments, the hole transport layer comprises a crosslinked structure generated by crosslinking a first crosslinking agent with a hole transport material.

In some embodiments, a content ratio of the first wavelength light absorbing molecule in the first wavelength light blocking layer is greater than a content ratio of the first crosslinking agent in the hole transport layer.

In some embodiments, the first wavelength light blocking layer further comprises a polymer molecule.

In some embodiments, the first wavelength light absorbing molecules comprise a bisazide group, and the first wavelength light blocking layer comprises a crosslinked structure generated by crosslinking the first wavelength light absorbing molecule with the polymer molecule.

In some embodiments, the first wavelength light blocking layer further comprises a remaining first wavelength light absorbing molecule.

In some embodiments, the quantum dot light-emitting layer comprises a plurality of quantum dots, at least some of the plurality of quantum dots comprise quantum dot bodies and ligands coordinated on the quantum dot bodies, and the polymer molecule is also crosslinked with at least some ligands through the bisazide group.

In some embodiments, a material of the polymer molecule is same as the hole transport material.

In some embodiments, the hole transport layer further comprises a remaining first crosslinking agent.

In some embodiments, the first wavelength light absorbing molecule comprises a benzophenone group or a monoazide group, and the first wavelength light absorbing molecule has a same light absorbing characteristic as the first crosslinking agent.

In some embodiments, in the first wavelength light blocking layer, the first wavelength light absorbing molecule is connected with the polymer molecule through a chemical bond, and the polymer molecule is uncrosslinked.

In some embodiments, the quantum dot light-emitting layer comprises a plurality of quantum dots, at least some of the plurality of quantum dots comprise quantum dot bodies and ligands coordinated on the quantum dot bodies, and the first wavelength light absorbing molecule is connected with at least some ligands through chemical bonds.

In some embodiments, a thickness of the first wavelength light blocking layer is less than or equal to 2nm.

In some embodiments, the quantum dot light-emitting layer has a crosslinked structure and comprises quantum dots, a second crosslinking agent, and the first wavelength light absorbing molecule, and the quantum dots are at least crosslinked with the second crosslinking agent.

In some embodiments, the first wavelength light absorbing molecule comprises a bisazide group.

In some embodiments, the first wavelength light absorbing molecule comprises a benzophenone group or a monoazide group.

In some embodiments, the first wavelength light absorbing molecule comprises a monoazide group, and a para group of the azide group comprises any one of alkyl, ether, alcohol and halogen; or the first wavelength light absorbing molecule comprises a benzophenone group, and a benzene ring on the benzophenone group is not connected with an electron-donating group.

In some embodiments, the light-emitting layer further comprises: a hole injection layer between the substrate and the hole transport layer; an electron transport layer at a side of the quantum dot light-emitting layer away from the substrate; and a second electrode at a side of the electron transport layer away from the substrate, wherein the substrate is a first electrode.

In some embodiments, the first wavelength light blocking layer is between the hole transport layer and the quantum dot light-emitting layer, the hole transport layer comprises a crosslinked structure generated by crosslinking a first crosslinking agent with a hole transport material, the first wavelength light blocking layer further comprises a polymer molecule, a material of the polymer molecule is same as the hole transport material, a material of the first wavelength light absorbing molecule is same as a material of the first crosslinking agent, the first wavelength light blocking layer comprises a crosslinked structure generated by crosslinking the first wavelength light absorbing molecule with the polymer molecule, and the quantum dot light-emitting layer comprises a crosslinked structure generated by crosslinking the second crosslinking agent with quantum dots.

According to another aspect of the present disclosure, a display device is provided, which comprises a plurality of light-emitting devices described in any of the previous embodiments.

According to yet another aspect of the present disclosure, a method of manufacturing a light-emitting device is provided, comprising: providing a substrate; providing a first mixed solution comprising a hole transport material and a first crosslinking agent on the substrate, curing the first mixed solution to form a first cured layer, and irradiating the first cured layer with a first wavelength light to crosslink the first crosslinking agent with the hole transport material to form a hole transport layer; providing a first wavelength light absorbing molecule on a side of the hole transport layer away from the substrate; providing a second mixed solution on the side of the hole transport layer away from the substrate, wherein the second mixed solution comprises quantum dots and a second crosslinking agent, and curing the second mixed solution to form a second cured layer; and irradiating the second cured layer with a third wavelength light to at least crosslink the second crosslinking agent with the quantum dots, wherein the third wavelength light comprises the first wavelength light, and the first wavelength light absorbing molecule absorb the first wavelength light in the third wavelength light to avoid the first wavelength light in the third wavelength light from irradiating the hole transport layer.

In some embodiments, providing the first wavelength light absorbing molecule on the side of the hole transport layer away from the substrate comprises: providing a third mixed solution comprising a polymer molecule and the first wavelength light absorbing molecule on the side of the hole transport layer away from the substrate, and applying the third mixed solution on the hole transport layer to form a first wavelength light blocking layer.

In some embodiments, the first wavelength light absorbing molecule comprises a bisazide group, and the third wavelength light further comprises a second wavelength light, wherein irradiating the second cured layer with the third wavelength light to at least crosslink the second crosslinking agent with the quantum dots comprises: the second crosslinking agent absorbing the second wavelength light in the third wavelength light and crosslinking with the quantum dots to form a quantum dot light-emitting layer, and the first wavelength light absorbing molecule absorbing the first wavelength light in the third wavelength light and crosslinking with the polymer molecule.

In some embodiments, the quantum dots comprise quantum dot bodies and ligands coordinated on the quantum dot bodies, wherein irradiating the second cured layer with the third wavelength light to at least crosslink the second crosslinking agent with the quantum dots further comprises: under the irradiation of the first wavelength light in the third wavelength light, the polymer molecule also crosslinking with the ligands through the bisazide group.

In some embodiments, the first wavelength light absorbing molecule comprises a monoazide group or a benzophenone group, the quantum dots comprise quantum dot bodies and ligands coordinated on the quantum dot bodies, and the third wavelength light further comprises a second wavelength light, wherein irradiating the second cured layer with the third wavelength light to at least crosslink the second crosslinking agent with the quantum dots comprises: the second crosslinking agent absorbing the second wavelength light in the third wavelength light and crosslinking with the quantum dots to form a quantum dot light-emitting layer, and the first wavelength light absorbing molecule absorbing the first wavelength light in the third wavelength light and connecting with the polymer molecule through a chemical bond; or the second crosslinking agent absorbing the second wavelength light in the third wavelength light and crosslinking with the quantum dots to form a quantum dot light-emitting layer, and the first wavelength light absorbing molecule absorbing the first wavelength light in the third wavelength light and connecting with the ligands through a chemical bond.

In some embodiments, providing the first wavelength light absorbing molecule at the side of the hole transport layer away from the substrate and providing the second mixed solution at the side of the hole transport layer away from the substrate comprises: providing the second mixed solution on the side of the hole transport layer away from the substrate, wherein the second mixed solution comprises the quantum dots, the second crosslinking agent and the first wavelength light absorbing molecule, and curing the second mixed solution to form the second cured layer.

In some embodiments, the first wavelength light absorbing molecule comprises a bisazide group, and the third wavelength light further comprises a second wavelength light, wherein irradiating the second cured layer with the third wavelength light to at least crosslink the second crosslinking agent with the quantum dots comprises: the second crosslinking agent absorbing the second wavelength light in the third wavelength light and crosslinking with the quantum dots, and the first wavelength light absorbing molecule absorbing the first wavelength light in the third wavelength and crosslinking with the quantum dots to form a quantum dot light-emitting layer.

In some embodiments, the first wavelength light absorbing molecule comprises a monoazide group or a benzophenone group, the quantum dots comprise quantum dot bodies and ligands coordinated on the quantum dot bodies, and the third wavelength light further comprises a second wavelength light, wherein irradiating the second cured layer with the third wavelength light to at least crosslink the second crosslinking agent with the quantum dots comprises: the second crosslinking agent absorbing the second wavelength light in the third wavelength light and crosslinking with the quantum dots to form a quantum dot light-emitting layer, and the first wavelength light absorbing molecule absorbing the first wavelength light in the third wavelength light and connecting with the ligands through a chemical bond.

In some embodiments, the concentration ratio of the hole transport material to the first crosslinking agent in the first mixed solution is 8 mg/ml: 0.05-0.5 mg/ml.

### BRIEF DESCRIPTION OF THE DRAWINGS

In the following, exemplary embodiments of the present disclosure will be described in detail with reference to the accompanying drawings, in which:
Fig. 1 illustrates a flowchart of a manufacturing method of a light-emitting device;
Fig. 2 illustrates a chemical formula of a hole transport material;
Fig. 3 illustrates current densities of a light-emitting device before and after exposure of a quantum dot light-emitting layer;
Fig. 4 illustrates device efficiencies of a light-emitting device before and after exposure of a quantum dot light-emitting layer;
Fig. 5 illustrates an arrangement of first wavelength light absorbing molecules in a light-emitting device according to an embodiment of the present disclosure;
Fig. 6 illustrates a chemical formula of a first wavelength light absorbing molecule according to an embodiment of the present disclosure;
Fig. 7 illustrates another chemical formula of a first wavelength light absorbing molecule according to an embodiment of the present disclosure;
Fig. 8 illustrates another chemical formula of a first wavelength light absorbing molecule according to an embodiment of the present disclosure;
Fig. 9 illustrates another chemical formula of a first wavelength light absorbing molecule according to an embodiment of the present disclosure;
Fig. 10 illustrates another chemical formula of a first wavelength light absorbing molecule according to an embodiment of the present disclosure;
Fig. 11 illustrates another chemical formula of a first wavelength light absorbing molecule according to an embodiment of the present disclosure;
Fig. 12 illustrates another chemical formula of a first wavelength light absorbing molecule according to an embodiment of the present disclosure;
Fig. 13 illustrates another chemical formula of a first wavelength light absorbing molecule according to an embodiment of the present disclosure;
Fig. 14 illustrates another arrangement of first wavelength light absorbing molecules in a light-emitting device according to an embodiment of the present disclosure;
Fig. 15 illustrates yet another arrangement of first wavelength light absorbing molecules in a light-emitting device according to an embodiment of the present disclosure;
Fig. 16 illustrates a structural schematic diagram of a light-emitting device according to an embodiment of the present disclosure;
Fig. 17 illustrates a structural schematic diagram of another light-emitting device according to an embodiment of the present disclosure;
Fig. 18 illustrates a structural schematic diagram of yet another light-emitting device according to an embodiment of the present disclosure;
Fig. 19 illustrates a block diagram of a display device according to an embodiment of the present disclosure; and
Fig. 20 illustrates a flowchart of a method of manufacturing a light-emitting device according to an embodiment of the present disclosure.

It should be understood that the drawings are only schematic illustrations of exemplary embodiments of the present disclosure, which are not limitations of the present disclosure and need not be drawn to scale. In addition, in the drawings, the same or similar parts are indicated by the same or similar reference numbers.

### DETAILED DESCRIPTION OF THE DISCLOSURE

In the following, the technical solutions in the embodiments of the disclosure will be described clearly and completely in connection with the drawings in the embodiments of the disclosure. Obviously, the described embodiments are only part of the embodiments of the disclosure, and not all of the embodiments. Based on the embodiments in the present disclosure, all other embodiments obtained by those of ordinary skills in the art under the premise of not paying out creative work pertain to the protection scope of the disclosure.

Before formally describing the technical solutions of the embodiments of the present disclosure, the following explanations and definitions are given to terms used in the embodiments of the present disclosure, so as to help those skilled in the art to understand the technical solutions of the embodiments of the present disclosure more clearly.

In the present disclosure, the term "crosslinking agent" may also be called bridging agent, which can generate diradical after exposure. Crosslinking agent is mainly used in polymer materials, which are linear molecules before crosslinking, with low strength, easy to be broken and inelastic. Crosslinking agent can produce chemical bonds between linear molecules, so that linear molecules are connected with each other to form a network structure, which can improve the strength, elasticity, stability and solvent resistance of polymer materials.

In the present disclosure, terms such as "crosslinking" or "crosslinking reaction" refer to a reaction in which two or more molecules (generally linear molecules) are bonded and crosslinked with each other to form a more stable molecule (body molecule) with a network structure. This reaction transforms linear or slightly branched macromolecules into three-dimensional network structure, thus improving the properties such as strength, heat resistance, abrasive resistance and solvent resistance. The crosslinking manner may be chemical crosslinking or physical crosslinking. Generally, chemical crosslinking is realized by polycondensation and polyaddition, and it is formed by covalent bonding, such as vulcanization of rubber and curing of unsaturated polyester resin. Physical crosslinking uses radiation such as light and heat to crosslink linear polymers, which are usually combined by physical forces such as hydrogen bonds. For example, radiation crosslinking of polyethylene belongs to physical crosslinking. After moderate crosslinking, linear polymers are improved in mechanical strength, elasticity, dimensional stability and solvent resistance, therefore crosslinking reaction can be used in modification of polymers.

In the present disclosure, the term "uncrosslinked" means that the molecular structure is basically kept in its original state, and it has not changed from linear molecules to a three-dimensional network structure. For example, uncrosslinked polymer molecules are still linear molecules.

In the present disclosure, terms such as "A is connected to B through a chemical bond" mean that A is bonded to B through a chemical bond. For example, A may be bonded to an atom on the surface of B or to a ligand of B through a chemical bond; Similarly, B may be bonded to an atom on the surface of A or to a ligand of A through a chemical bond.

In the present disclosure, terms such as "A is connected to B through a chemical bond but uncrosslinked with B" mean that after a specific reaction, A is only connected to s atom on the surface of B or a ligand of B through a chemical bond, but does not participate in the crosslinking process of B, that is, A does not change B from linear molecules to a three-dimensional network structure.

The quantum dot light-emitting diode device comprises an upright device structure and an inverted device structure, wherein the upright device structure comprises an anode, a hole injection layer, a hole transport layer, a quantum dot light-emitting layer, an electron transport layer, a cathode and other film layers stacked in sequence. In the preparation process of the upright device structure, the lithography patterning process involves the exposure and crosslinking of the hole transport layer and the quantum dot light-emitting layer respectively.

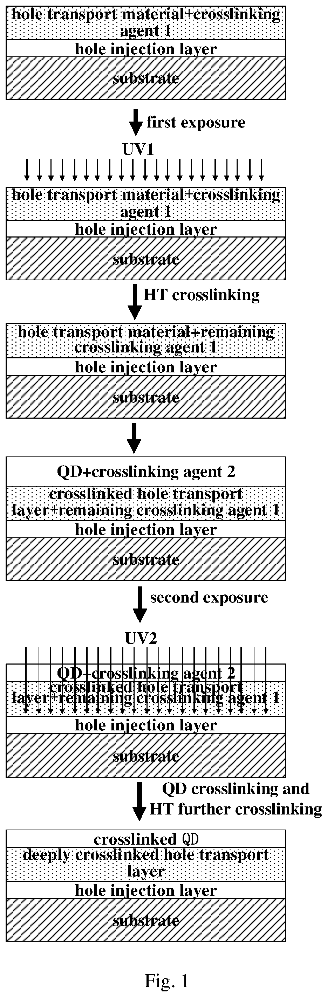

Fig. 1 illustrates a flowchart of preparation of partial film layers in a quantum dot light emitting diode device. As shown in Fig. 1, firstly, a substrate is provided, then a hole injection layer is formed on the substrate, then a mixed solution comprising a hole transport material and a crosslinking agent 1 is applied on the hole injection layer and cured to form a first intermediate film layer, then the first intermediate film layer is exposed by UV1 to undergo the first exposure, and the crosslinking agent 1 absorbs UV1 and crosslinks with the hole transport material to form a crosslinked hole transport layer. Since the crosslinking agent 1 in the mixed solution is usually excessive, the hole transport layer comprises remaining uncrosslinked crosslinking agent 1 in addition to the crosslinked hole transport layer. Then, a mixed solution comprising quantum dots QD and a crosslinking agent 2 is applied on the hole transport layer (comprising crosslinked hole transport layer and remaining uncrosslinked crosslinking agent 1) and cured to form a second intermediate film layer, and then the second intermediate film layer is exposed by UV2 to undergo the second exposure. In addition to the main waveband UV2, UV2 also comprises wavebands such as UV1. The crosslinking agent 2 absorbs UV2 in the main waveband and crosslinks quantum dots QD to form a crosslinked quantum dot light-emitting layer. However, in the second exposure process, UV2 will not be completely absorbed by the quantum dot light-emitting layer and the crosslinking agent 2, but will pass through the quantum dot light-emitting layer and irradiate the hole transport layer. Since UV2 also comprises UV1 and other wavebands, and the hole transport layer comprises remaining uncrosslinked crosslinking agent 1, the remaining uncrosslinked crosslinking agent 1 will further absorb UV1 waveband in UV2, so that the hole transport layer will be further crosslinked to form a deeply crosslinked hole transport layer.

It is found that the crosslinking of the hole transport material will reduce the hole mobility of hole transport layer, which will lead to the decrease of hole transport ability of hole transport layer. Specifically, the inventor tested the quantum dot light-emitting diode device, and only exposed the uncrosslinked hole transport layer with UV1 without exposing the quantum dot light-emitting layer with UV2. The results show that the hole transport ability of the hole transport layer is reduced by about one time after exposure, which indicates that the crosslinking of the crosslinking agent 1 and the hole transport material will lead to the decrease of the hole transport ability of the hole transport layer.

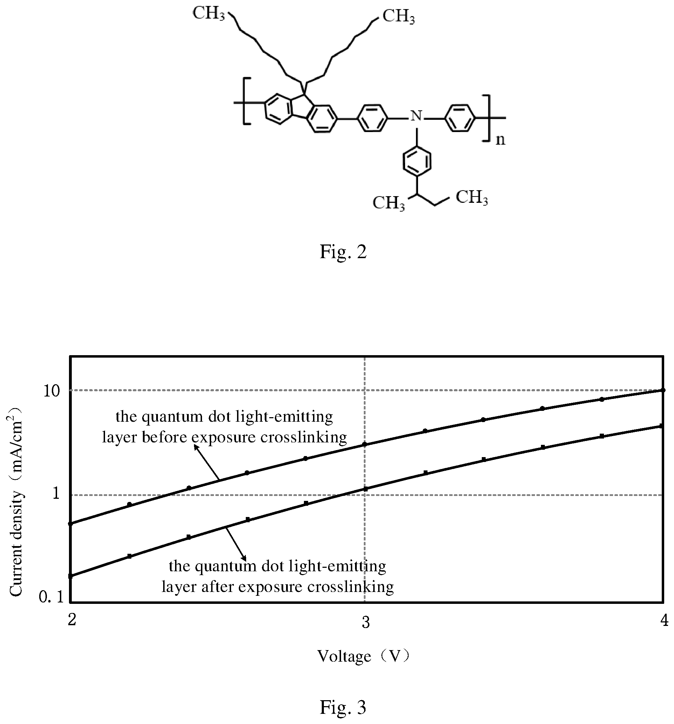

In fact, this is understandable. Fig. 2 shows the molecular structure of a commonly used hole transport material, called polymer TFB for short. Polymer TFB forms a certain degree of ordered film structure by orderly stacking of benzene rings. The order degree of polymer semiconductor stack is an important factor to improve the carrier mobility (that is, carrier transport ability) of polymer semiconductor film. However, during the crosslinking process, the crosslinking agent 1 will bond with the molecular chain of polymer TFB, which will destroy the orderly stacked film structure, thus reducing the hole transport ability of the hole transport layer.

Referring to Fig. 1, in the second exposure process, the remaining uncrosslinked crosslinking agent 1 in the hole transport layer will further absorb the UV1 waveband in UV2, so that the hole transport layer will be further crosslinked to form a deeply crosslinked hole transport layer, so that the hole transport ability of the hole transport layer will be further reduced, which will lead to a significant reduction in the efficiency of the quantum dot light emitting diode device.

Fig. 3 shows current densities of a quantum dot light emitting diode device before and after exposure crosslinking of the quantum dot light-emitting layer. As shown in Fig. 3, the current density of the device after exposure crosslinking decreased to about 40% of the current density of the device before exposure crosslinking. In the process of exposing quantum dots, the remaining uncrosslinked crosslinking agent 1 in the hole transport layer will further absorb the UV1 waveband in UV2, so that the hole transport layer will be further crosslinked to form a deeply crosslinked hole transport layer, and the hole mobility of the hole transport layer will further decrease (for example, by more than 50%). The decrease of hole mobility will lead to the decrease of current density of the quantum dot light emitting diode device.

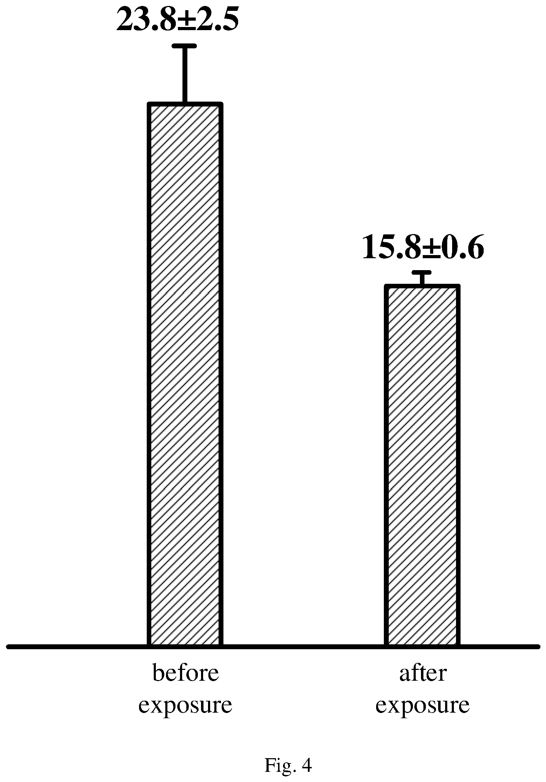

Fig. 4 shows the external quantum efficiency (EQE) of the quantum dot light-emitting diode device of Fig. 3 before and after exposure crosslinking of the quantum dot light-emitting layer. In a quantum dot light emitting diode device, the hole mobility of the hole transport layer is usually significantly lower than the electron mobility of the electron transport layer. In the process of quantum dot exposure, the remaining uncrosslinked crosslinking agent 1 in the hole transport layer further absorbs the UV1 waveband in UV2, which will further reduce the hole mobility of the hole transport layer, resulting in a more unbalanced electron and hole transport ability in the quantum dot light emitting diode device, which will lead to a significant decrease in EQE of the quantum dot light emitting diode device, for example, EQE decreases by about 30% to 40%. As shown in Fig. 4, before exposure crosslinking, the EQE of the quantum dot light emitting diode device is 23.8%±2.5%; after exposure crosslinking, the EQE of quantum dot light-emitting diode device decreases to 15.8%±0.6%, a decrease is about 33%.

In order to solve the problems existing in the prior art, some embodiments of the present disclosure provide some design schemes, which can reduce or even eliminate the amount of ultraviolet light reaching the hole transport layer when the quantum dot light-emitting layer is exposed, so that the hole transport layer can be prevented from further crosslinking, thereby avoiding reducing the hole mobility of the hole transport layer.

Some embodiments of the present disclosure provide a light-emitting device. The light-emitting device comprises a substrate, a hole transport layer on the substrate, a quantum dot light-emitting layer on a side of the hole transport layer away from the substrate, and a first wavelength light absorbing molecule on a side of the hole transport layer away from the substrate. The first wavelength light absorbing molecule may absorb a first wavelength light capable of causing the hole transport layer to undergo a crosslinking reaction.

In the preparation process of light-emitting devices, it involves the exposure crosslinking of hole transport layer and quantum dot light-emitting layer respectively. The quantum dot light-emitting layer can be exposed and crosslinked by a third wavelength light, the third wavelength light comprises at least the first wavelength light and the second wavelength light. The second wavelength light can be used to crosslink the quantum dots, and the first wavelength light can cause the hole transport layer to crosslink. In various disclosed embodiments, by providing first wavelength light absorbing molecules on the side of the hole transport layer away from the substrate, the first wavelength light absorbing molecules can absorb the first wavelength light, so that when the quantum dot light-emitting layer above the hole transport layer is exposed and crosslinked, even though the third wavelength light will pass through the quantum dot light-emitting layer, the first wavelength light in the third wavelength light will not reach the hole transport layer, but will be absorbed by the first wavelength light absorbing molecules before reaching the hole transport layer. In this way, the hole transport layer will not be further crosslinked, thus avoiding the decrease of hole mobility of the hole transport layer and avoiding the influence on the efficiency of the light-emitting device.

The first wavelength light absorbing molecules may be between the hole transport layer and the quantum dot light-emitting layer, or may be in the quantum dot light-emitting layer, or may be on the side of the quantum dot light-emitting layer away from the substrate, as long as it is ensured that when the quantum dot light-emitting layer is exposed and crosslinked, the first wavelength light absorbing molecules can absorb the first wavelength light in the third wavelength light before it reaches the hole transport layer.

In the following, different arrangements of first wavelength light absorbing molecules in light-emitting devices are described in several embodiments.

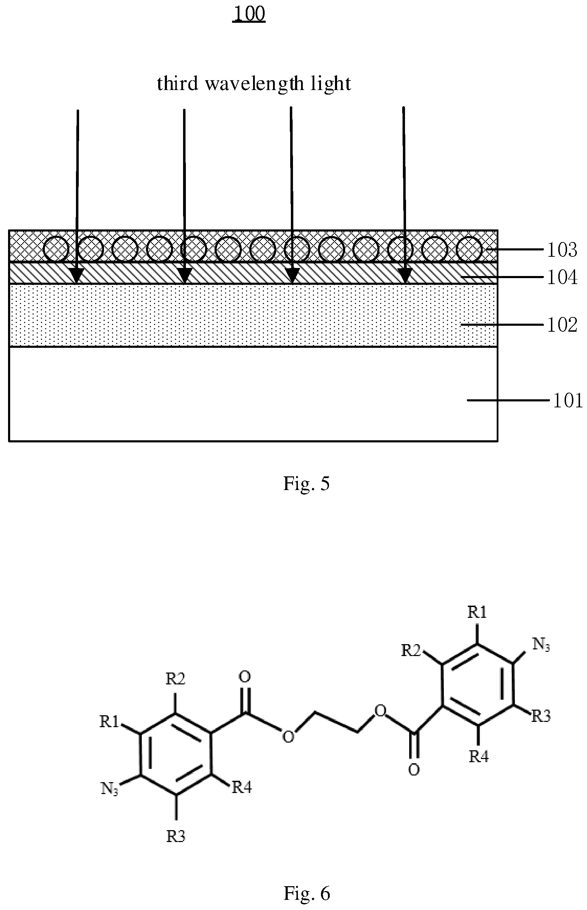

Fig. 5 shows a light-emitting device 100 according to an embodiment of the present disclosure. The light-emitting device 100 comprises a substrate 101; a hole transport layer 102 on the substrate 101; a first wavelength light blocking layer 104 on a side of the hole transport layer 102 away from the substrate 101, the first wavelength light blocking layer 104 comprises the above-mentioned first wavelength light absorbing molecules, which can absorb the first wavelength light that can cause the crosslinking reaction of the hole transport layer 102; and a quantum dot light-emitting layer 103 on a side of the first wavelength light blocking layer 104 away from the substrate 101.

The manufacturing process of the light-emitting device 100 is roughly as follows.

First, a substrate 101 is provided, which may be, for example, an anode of the light-emitting device 100, and a material of the substrate 101 may be any suitable material, such as ITO.

Then, a first mixed solution comprising a hole transport material and a first crosslinking agent is provided on the substrate 101. Curing the first mixed solution to form a first cured layer. A first exposure process is performed, that is, the first cured layer is irradiated with the first wavelength light to crosslink the first crosslinking agent with the hole transport material to form the hole transport layer 102.

The first wavelength light may be ultraviolet light, and illustratively, the first wavelength light may be ultraviolet light of 254nm. The hole transport material may be any suitable material, comprising but not limited to TFB (Poly (9,9-dioctylphluorene-alt-N-(4-secbutylphenyl)-diphenylamine), Poly TPD (Poly [N,N'-bis(4-butylphenyl)-N,N'-bis(phenyl)-benzi) and PVK(Polyvinylcarbazole). The first crosslinking agent may be a crosslinking agent molecule such as azide system, diazo system, benzophenone system, etc. The hole transport layer 102 comprises a crosslinked structure generated by crosslinking a hole transport material with a first crosslinking agent. In some embodiments, the hole transport layer 102 is a composite system, and besides the crosslinked structure, the hole transport layer 102 also comprises the remaining first crosslinking agent. Here, the "remaining first crosslinking agent" refers to the excessive first crosslinking agent that does not participate in the crosslinking reaction. In the first mixed solution, the first crosslinking agent may be excessive. After the first exposure crosslinking, all the hole transport materials in the first mixed solution have been crosslinked, and some of the first crosslinking agent will remain without crosslinking.

Then, a third solution is provided on the side of the hole transport layer 102 away from the substrate 101. In some embodiment, the third solution may be a solution of the first wavelength light absorbing molecules. In an alternative embodiment, the third solution is a mixed solution, which comprises a polymer molecule solution and a first wavelength light absorbing molecule solution. In the case of mixed solution, the mixed solution of the polymer molecule solution and the first wavelength light absorbing molecule solution may be applied to, by spin coating or blade coating, the hole transport layer 102 which has complete the first exposure crosslinking, to form the first wavelength light blocking layer 104. The first wavelength light blocking layer 104 is a composite film composed of polymer molecules and the first wavelength light absorbing molecules. Since the first wavelength light absorbing molecules are usually small organic molecules, it is not conducive to the application of solution film forming method. Polymer molecules are macromolecules, so the mixed solution composed of polymer molecules and the first wavelength light absorbing molecules may be beneficial to the application of solution film forming method. Polymer molecules may be the same as hole transport materials, such as TFB, PVK, Poly-TPD, etc., and may also be other polymer molecules that are easy to form films.

Then, a second mixed solution comprising quantum dots and a second crosslinking agent is provided on a side of the first wavelength light blocking layer 104 away from the substrate 101, and the second mixed solution is cured to form a second cured layer. The second crosslinking agent may be any suitable crosslinking agent capable of crosslinking the quantum dots, which is not limited by the embodiments of the present disclosure. For example, the second crosslinking agent may be a benzophenone crosslinking agent.

Finally, the second exposure process is performed, that is, the second cured layer is irradiated with a third wavelength light. The third wavelength light comprises not only the second wavelength light (for example, 365nm) that can crosslink quantum dots, but also the first wavelength light (for example, 254nm, 0.047mW/cm²) and other wavebands light (for example, 405nm, 5mW/cm²). The second crosslinking agent absorbs the second wavelength light and performs crosslinking reaction with the quantum dots to form the quantum dot light-emitting layer 103. At least the first wavelength light in the third wavelength light passes through the quantum dot light-emitting layer 103 and is absorbed by the first wavelength light absorbing molecules in the first wavelength light blocking layer 104. Depending on the material type of the first wavelength light absorbing molecules, the first wavelength light absorbing molecules in the first wavelength light blocking layer 104 may or may not crosslink with polymer molecules after being irradiated with the first wavelength light, which will be described in detail hereinafter.

It can be seen that by arranging the first wavelength light blocking layer 104 between the hole transport layer 102 and the quantum dot light-emitting layer 103, when the exposure process is performed on the quantum dot light-emitting material, even though the first wavelength light in the third wavelength light will pass through the quantum dot light-emitting layer 103, the first wavelength light will not reach the hole transport layer 102, but will be absorbed by the first wavelength light absorbing molecules in the first wavelength light blocking layer 104 before reaching the hole transport layer 102. In this way, the hole transport layer 102 will not be further crosslinked, so that the decrease of the hole mobility of the hole transport layer 102 can be avoided and the influence on the efficiency of the light-emitting device 100 can be avoided.

Illustratively, the first wavelength light blocking layer 104 may include an azide group or a benzophenone group. Both azide group and benzophenone group can absorb the first wavelength light.

Illustratively, the thickness of the first wavelength light blocking layer 104 is less than or equal to 2nm, and may be, for example, 0.5nm, 1.0nm, 1.5nm, 2.0nm.

Illustratively, the content ratio of the first wavelength light absorbing molecules in the first wavelength light blocking layer 104 is larger than the content ratio of the first crosslinking agent in the hole transport layer 102. It should be noted that the first wavelength light absorbing molecules here comprise crosslinked first wavelength light absorbing molecules in the first wavelength light blocking layer 104 and uncrosslinked remaining first wavelength light absorbing molecules in the first wavelength light blocking layer 104. Similarly, the first crosslinking agent here comprises the crosslinked first crosslinking agent in the hole transport layer 102 and the uncrosslinked remaining first crosslinking agent in the hole transport layer 102. Illustratively, "content ratio" may refer to mass percentage.

The first wavelength light absorbing molecules in the first wavelength light blocking layer 104 may be various suitable materials, and some possible material choices of the first wavelength light absorbing molecules will be listed below. It should be noted that the materials listed below are only some optional materials of the first wavelength light absorbing molecules, and the first wavelength light absorbing molecules are not limited to these listed materials.

Fig. 6 illustrates a chemical formula of a first wavelength light absorbing molecule, which is 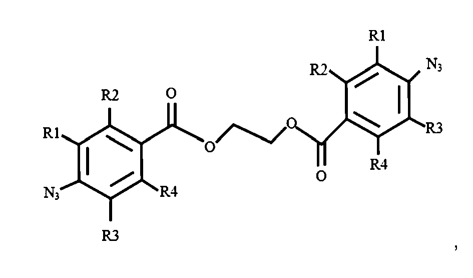 that is, each first wavelength light absorbing molecule comprises two azide groups, which is referred to as bisazide molecules for short. R1 to R4 may be the same as or different from each other and may be selected from fluorine atoms or hydrogen atoms, respectively. The azide group N3 in the first wavelength light absorbing molecule can generate nitrogen carbene radical under the radiation of the first wavelength light, the nitrogen carbene radical has high activity and can crosslink with polymer molecules, so that the first wavelength light blocking layer 104 comprises a crosslinked structure. When the para-position, ortho-position or inter-position of the azide group N3 is a fluorine atom, it is beneficial to better stabilize the nitrogen carbene radical and promote the crosslinking reaction between the first wavelength light absorbing molecule and the polymer molecule.

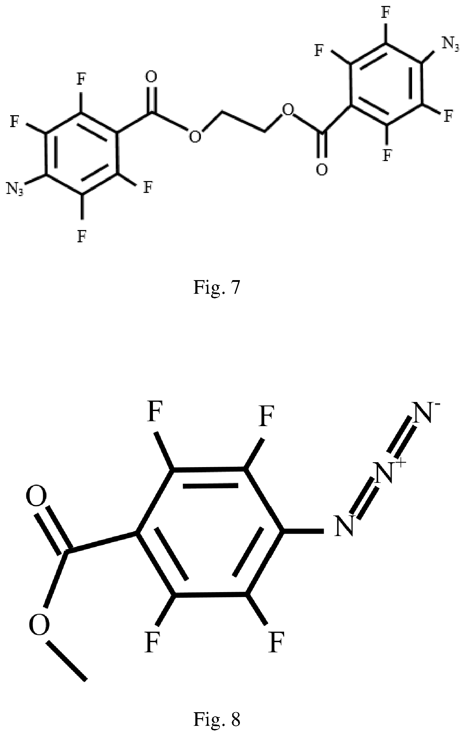

As shown in Fig. 7, when R1~R4 are all fluorine atoms, the chemical formula in Fig. 6 becomes

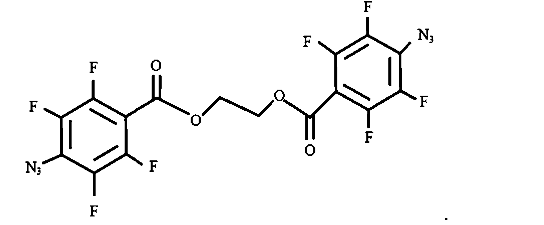

When the first wavelength light absorbing molecules have the molecular structure shown in Fig. 6 or Fig. 7, in the second exposure process, the first wavelength light absorbing molecules in the first wavelength light blocking layer 104 absorb the first wavelength light in the third wavelength light and crosslink with polymer molecules, so that the first wavelength light blocking layer 104 comprises the crosslinked structure.

In some embodiments, in addition to the crosslinked structure, the first wavelength light blocking layer 104 also comprises the remaining first wavelength light absorbing molecules, that is, the first wavelength light blocking layer 104 is a composite film layer. Similarly, the term "remaining first wavelength light absorbing molecules" here refers to excessive first wavelength light absorbing molecules that have not participated in the crosslinking reaction. In order to ensure that the thin first wavelength light blocking layer 104 can fully absorb the first wavelength light in the second exposure process, the first wavelength light absorbing molecules in the first wavelength light blocking layer 104 are usually excessive. After the second exposure process, all polymer molecules have been crosslinked, while some first wavelength light absorbing molecules remain without crosslinking.

The quantum dot light-emitting layer 103 is formed by crosslinking a plurality of quantum dots with a second crosslinking agent. In some embodiments, quantum dots comprise quantum dot bodies and ligands coordinated on the quantum dot bodies. During the second exposure process, under the radiation of the first wavelength light in the third wavelength light, the polymer molecules in the first wavelength light blocking layer 104 not only crosslink with the first wavelength light absorbing molecules, but also may crosslink with the ligands of at least some of the quantum dots through bisazide groups.

In some embodiments, the material of the first wavelength light absorbing molecule in the first wavelength light blocking layer 104 may be the same as the material of the first crosslinking agent in the hole transport layer 102. For example, the first wavelength light absorbing molecule and the first crosslinking agent can both be bisazide molecules, such as the molecular structure shown in Fig. 6 or Fig. 7. Bisazide molecules can fully absorb first wavelength light. In still other embodiments, the material of polymer molecules in the first wavelength light blocking layer 104 may be the same as the hole transport material in the hole transport layer 102, such as **TFB,** polyTPD, PVK, etc.

In some embodiments, the polymer molecule is **TFB,** and the first wavelength light absorbing molecule is a bisazide molecule. When preparing a third mixed solution comprising polymer molecules and first wavelength light absorbing molecules, in some examples, the concentration ratio of the polymer molecule solution to the first wavelength light absorbing molecule solution may be 0.8 mg/ml: 0.5 mg/ml, and the thickness of the formed first wavelength light blocking layer 104 is about 2nm. In still other examples, the concentration ratio of the polymer molecule solution to the first wavelength light absorbing molecule solution may be 0.5 mg/ml: 0.5 mg/ml, and the thickness of the formed first wavelength light blocking layer 104 is about 1nm. In still other examples, when the thickness of the first wavelength light blocking layer 104 is required to be less than 1nm, the concentration of the first wavelength light absorbing molecules in the third mixed solution is not less than the concentration of the first crosslinking agent in the first mixed solution (comprising the hole transport material and the first crosslinking agent).

The inventors conducted a comparative experiment between the light-emitting device of Fig. 1 (QLED device 1 for short) and the light-emitting device 100 of Fig. 5. The hole transport layer and quantum dot light-emitting layer of QLED device 1 were exposed in two steps respectively, and the hole transport layer 102 and quantum dot light-emitting layer 103 of light-emitting device 100 were exposed in two steps respectively. After testing, the hole current density of light-emitting device 100 was increased by about 4 times compared with the hole current density of QLED device 1. This is because the first wavelength light blocking layer 104 in the light-emitting device 100 absorbs the first wavelength light transmitted through the quantum dot light-emitting layer 103 in the second exposure process, which prevents the first wavelength light from radiating the hole transport layer 102, thus avoiding further reducing the hole transport ability of the hole transport layer 102. It can be seen that disposing the first wavelength light blocking layer 104 in the light-emitting device 100 can keep the hole transport ability of the hole transport layer 102 at a high level after the second exposure process.

In some embodiments, the material of the first wavelength light absorbing molecule is different from the material of the first crosslinking agent, however, the first wavelength light absorbing molecule has the same light absorbing characteristics as the first crosslinking agent. It should be noted that the phrase "the first wavelength light absorbing molecule has the same light absorbing characteristics as the first crosslinking agent" means that both the first wavelength light absorbing molecule and the first crosslinking agent can absorb light of the same waveband, for example, both can absorb first wavelength light.

For example, the first wavelength light absorbing molecule is not a bisazide molecule, but a molecule comprising a monoazide group. This kind of molecular structure can be, for example, half of the molecular structure of the bisazide.

Fig. 8 shows a molecular structure of the first wavelength light absorbing molecule, which is methyl 4-azido tetrafluorobenzoate 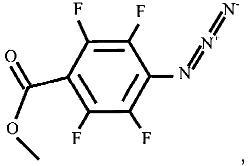 which is a monoazide molecule.

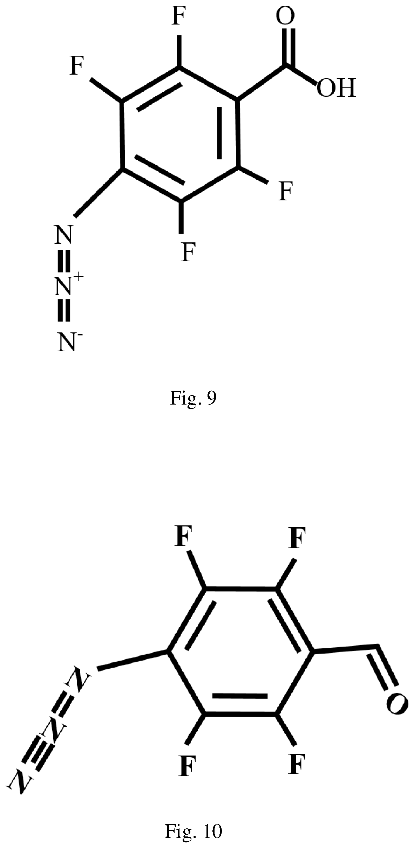

Fig. 9 shows another molecular structure of the first wavelength light absorbing molecule, which is 4-azido tetrafluorobenzoic acid 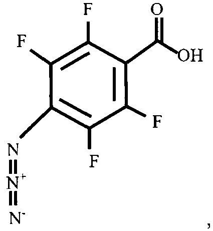 which is a monoazide molecule.

Fig. 10 shows another molecular structure of the first wavelength light absorbing molecule, which is 4-azido tetrafluorobenzaldehyde 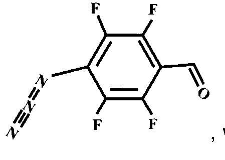 which is a monoazide molecule.

These monoazide molecules containing 4-azido tetrafluorophenyl can be the precursor molecules for synthesizing bisazide molecules. When the first wavelength light absorbing molecules are azide molecules such as those shown in Figs. 8 to 10, these first wavelength light absorbing molecules have the same UV absorption waveband as the first crosslinking agent, and can absorb the first wavelength light, so they can be used to absorb the first wavelength light in the second exposure process.

When the first wavelength light absorbing molecules are azide molecules such as those shown in Figs. 8 to 10, in the second exposure process, the first wavelength light absorbing molecules in the first wavelength light blocking layer 104 absorb the first wavelength light in the third wavelength light to generate nitrogen carbene radicals. In some cases, the first wavelength light absorbing molecules are connected to the polymer molecules by chemical bonds, but they will not crosslink with the polymer molecules, that is, they will not change the polymer molecules from linear molecules to three-dimensional network structures, and the polymer molecules are uncrosslinked. Or in other cases, the first wavelength light absorbing molecules are connected with the quantum dot ligands at the interface between the first wavelength light blocking layer 104 and the quantum dot light-emitting layer 103 through chemical bonds, but will not crosslink with the quantum dot ligands. This is beneficial, if the first wavelength light absorbing molecules crosslink with quantum dot ligands, the photoluminescence quantum efficiency (PLQY) of quantum dots may be reduced, which may lead to the problems of insufficient brightness of light-emitting devices. However, using monoazide molecules as first wavelength light absorbing molecules only absorb first wavelength light and generates single nitrogen carbene radicals, and the single nitrogen carbene radicals will not participate in the crosslinking process of quantum dots, thus avoiding the problems of insufficient brightness caused by the crosslinking of first wavelength light absorbing molecules with quantum dot ligands.

In some alternative embodiments, the material of the first wavelength light absorbing molecule is different from the material of the first crosslinking agent, and the first wavelength light absorbing molecule comprises a benzophenone group. Such first wavelength light absorbing molecules have the same light absorbing characteristics as the first crosslinking agent, and both of them can absorb first wavelength light.

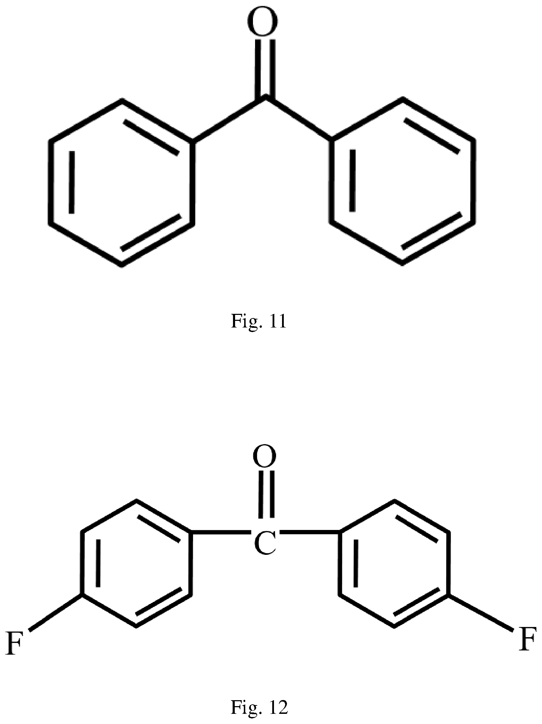

Fig. 11 shows a molecular structure of a first wavelength light absorbing molecule, which is benzophenone 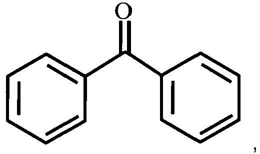 which is a benzophenone molecule.

Fig. 12 shows another molecular structure of the first wavelength light absorbing molecule, which is 4,4' difluorobenzophenone 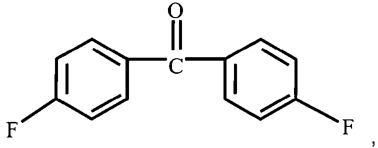 which is a benzophenone molecule.

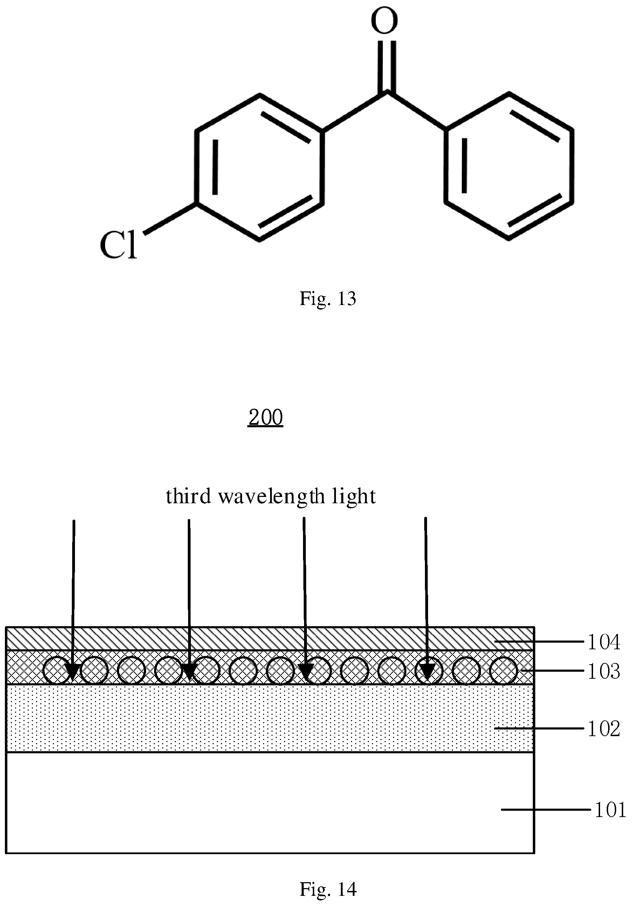

Fig. 13 shows another molecular structure of the first wavelength light absorbing molecule, which is 4-chlorobenzophenone 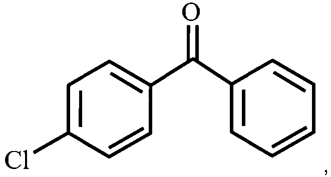 which is a benzophenone molecule.

When the first wavelength light absorbing molecules are benzophenone molecules such as those in Figs. 11 to 13, in the second exposure process, the first wavelength light absorbing molecules in the first wavelength light blocking layer 104 absorb the first wavelength light in the third wavelength light to generate carbon carbene radicals. In some cases, the first wavelength light absorbing molecules are connected to the polymer molecules by chemical bonds, but they will not crosslink with the polymer molecules, that is, they will not change the polymer molecules from linear molecules to three-dimensional network structures, and the polymer molecules are uncrosslinked. Or in other cases, the first wavelength light absorbing molecules are connected with the quantum dot ligand at the interface between the first wavelength light blocking layer 104 and the quantum dot light-emitting layer 103 through chemical bonds, but will not crosslink with the quantum dot ligand. This is beneficial, if the first wavelength light absorbing molecules crosslink with quantum dot ligands, the photoluminescence quantum efficiency (PLQY) of quantum dots may be reduced, which may lead to problems such as insufficient brightness of light-emitting devices. However, using benzophenone molecules as the first wavelength light absorbing molecules only absorb the first wavelength light but will not crosslink with quantum dot ligands, thus avoiding the problems of insufficient brightness of light-emitting devices.

It has been described above that the first wavelength light blocking layer 104 is provided between the hole transport layer 102 and the quantum dot light-emitting layer 103, and the first wavelength light blocking layer 104 comprises first wavelength light absorbing molecules. The first wavelength light absorbing molecules can be various appropriate types of molecules, such as bisazide molecules, monoazide molecules, benzophenone molecules. By arranging the first wavelength light blocking layer 104 between the hole transport layer 102 and the quantum dot light-emitting layer 103, when the quantum dot light-emitting material is exposed, even though the first wavelength light in the third wavelength light will pass through the quantum dot light-emitting layer 103, the first wavelength light will not reach the hole transport layer 102, but will be absorbed by the first wavelength light absorbing molecules in the first wavelength light blocking layer 104 before reaching the hole transport layer 102. In this way, the hole transport layer 102 will not be further crosslinked, thus avoiding the decrease of hole mobility of the hole transport layer 102 and avoiding the influence on the efficiency of the light-emitting device 100.

Fig. 14 shows a structural schematic diagram of a light-emitting device 200 according to another embodiment of the present disclosure. The light-emitting device 200 has basically the same configuration as the light-emitting device 100 except for the arrangement position of the first wavelength light blocking layer 104, and therefore the same reference numerals are used to refer to the same components. Therefore, the detailed functions of components in Fig. 14 with the same reference numerals as those in Fig. 5 can be referred to the description of Fig. 5, and will not be repeated here. For the sake of brevity, only the differences between the light-emitting device 200 and the light-emitting device 100 will be described below.

As shown in Fig. 14, the light-emitting device 200 comprises: a substrate 101; a hole transport layer 102 on the substrate 101; a quantum dot light-emitting layer 103 on a side of the hole transport layer 102 away from the substrate 101; and a first wavelength light blocking layer 104 on a side of the quantum dot light-emitting layer 103 away from the substrate 101, wherein the first wavelength light blocking layer 104 comprises the first wavelength light absorbing molecules, and the first wavelength light absorbing molecules can absorb the first wavelength light that can cause the hole transport layer 102 to undergo a crosslinking reaction.

The structure and function of the first wavelength light blocking layer 104 can refer to the description of the first wavelength light blocking layer 104 in Fig. 5. The material of the first wavelength light absorbing molecule may be the same as or different from the material of the first crosslinking agent. For example, the first wavelength light absorbing molecules may be bisazide molecules, such as the bisazide molecules shown in Figs. 6 and 7; the first wavelength light absorbing molecules may also be monoazide molecules, such as the monoazide molecules shown in Figs. 8 to 10; or the first wavelength light absorbing molecules may be benzophenone molecules, such as the benzophenone molecules shown in Figs. 11 to 13; or the first wavelength light absorbing molecules may be other suitable types of molecules.

In the manufacturing process of the light-emitting device 200, the substrate 101 and the hole transport layer 102 are first manufactured. Then, a second mixed solution comprising quantum dots and a second crosslinking agent is provided on the side of the hole transport layer 102 away from the substrate 101, and the second mixed solution is cured to form a second cured layer. Then, the second exposure process is not performed on the second cured layer, but the first wavelength light blocking layer 104 is formed on the side of the second cured layer away from the substrate 101. The formation method of the first wavelength light blocking layer 104 may refer to the previous description about Fig. 5. After the first wavelength light blocking layer 104 is formed, the first wavelength light blocking layer 104 is irradiated with a third wavelength light. The third wavelength light comprises the second wavelength light (for example, 365nm) that can crosslink the quantum dots, the first wavelength light (for example, 254nm, 0.047mW/cm²) that can further crosslink the hole transport layer 102, and other wavebands light (for example, 405nm, 5mW/cm²). The first wavelength light in the third wavelength light is absorbed by the first wavelength light absorbing molecules in the light blocking layer 104, so it is not radiated to the hole transport layer 102. The second wavelength light in third wavelength light passes through the first wavelength light blocking layer 104 and is absorbed by the second crosslinking agent, and the second crosslinking agent reacts with the quantum dots to form the quantum dot light-emitting layer 103.

It can be seen that by arranging the first wavelength light blocking layer 104 on the side of the quantum dot light-emitting layer 103 away from the substrate 101, the first wavelength light in the second exposure process can also be avoided from radiating the hole transport layer 102. In this way, the hole transport layer 102 will not be further crosslinked, thus avoiding the decrease of hole mobility of the hole transport layer 102 and avoiding the influence on the efficiency of the light-emitting device 200.

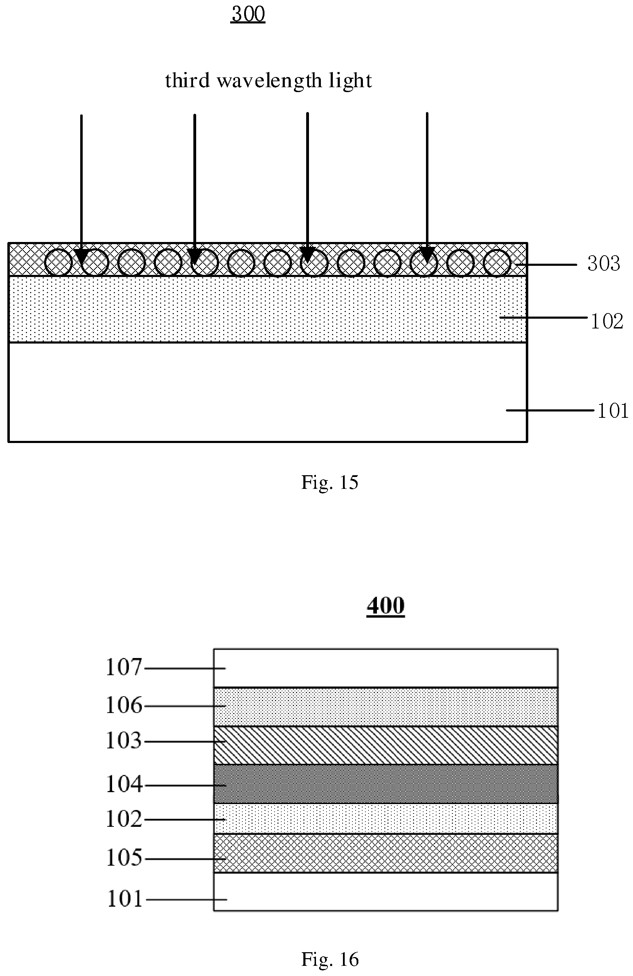

Fig. 15 shows a structural schematic diagram of a light-emitting device 300 according to another embodiment of the present disclosure. The light-emitting device 300 has basically the same configuration as the light-emitting device 100 except for the arrangement position of first wavelength light absorbing molecules, and therefore the same reference numerals are used to refer to the same components. Therefore, the detailed functions of components in Fig. 15 with the same reference numerals as those in Fig. 5 can be referred to the description of Fig. 5, and will not be repeated here. For the sake of brevity, only the differences between the light-emitting device 300 and the light-emitting device 100 will be described below.

As shown in Fig. 15, the light-emitting device 300 comprises: a substrate 101; a hole transport layer 102 on the substrate 101; and a quantum dot light-emitting layer 303 on a side of the hole transport layer 102 away from the substrate 101. The quantum dot light-emitting layer 303 has a crosslinked structure and comprises quantum dots, a second crosslinking agent, and first wavelength light absorbing molecules. The first wavelength light absorbing molecules and the first crosslinking agent can absorb ultraviolet light with the same waveband, for example, both of them can absorb the first wavelength light, and the second crosslinking agent can absorb the second wavelength light different from the first wavelength light, and the quantum dots are at least crosslinked with the second crosslinking agent.

In the manufacturing process of the light-emitting device 300, the substrate 101 and the hole transport layer 102 are first manufactured. Then, a second mixed solution comprising quantum dots, a second crosslinking agent, and the first wavelength light absorbing molecules is provided on the side of the hole transport layer 102 away from the substrate 101, and the second mixed solution is cured to form a second cured layer. The second crosslinking agent may be any suitable crosslinking agent capable of crosslinking the quantum dots, which is not limited by the embodiments of the present disclosure. For example, the second crosslinking agent may be a benzophenone crosslinking agent. In some embodiments, the concentration of first wavelength light absorbing molecules in the second mixed solution may be 0.2-0.5mg/ml, for example, 0.2mg/ml, 0.3mg/ml, 0.4mg/ml, 0.5 mg/ml. For example, in the second mixed solution, the concentration ratio of first wavelength light absorbing molecules to quantum dots may be 0.2 ~ 0.5 mg/ml: 20 mg/ml.

Then, a second exposure process is performed on the second cured layer, that is, the second cured layer is irradiated with the third wavelength light. The third wavelength light comprises not only the second wavelength light (for example, 365nm) that can crosslink quantum dots, but also the first wavelength light (for example, 254nm, 0.047mW/cm²) and other wavebands light (for example, 405nm, 5mW/cm²). Under the radiation of the third wavelength light, the second crosslinking agent absorbs the second wavelength light in the third wavelength light and performs crosslinking reaction with the quantum dots. The first wavelength light absorbing molecules absorb the first wavelength light in the third wavelength light. Depending on the material type of the first wavelength light absorbing molecules, the first wavelength light absorbing molecules may or may not crosslink with quantum dots, which will be described in detail hereinafter.

It can be seen that by adding the first wavelength light absorbing molecules in the quantum dot light-emitting layer 303, the first wavelength light absorbing molecules can absorb the first wavelength light involved in the second exposure process at the quantum dot light-emitting layer 303, without allowing it to radiate the hole transport layer 102. In this way, further crosslinking of the hole transport layer 102 can be avoided, and the decrease of hole mobility of the hole transport layer 102 can be avoided, thus contributing to improving the efficiency of the light-emitting device 300.

In some embodiments, the first wavelength light absorbing molecules in the quantum dot light-emitting layer 303 comprise bisazide groups. Illustratively, the first wavelength light absorbing molecule has the molecular structure shown in Fig. 6 or Fig. 7. In this case, in the second exposure process, the second crosslinking agent absorbs the second wavelength light in the third wavelength light and performs crosslinking reaction with the quantum dots, while the first wavelength light absorbing molecules absorb the first wavelength light in the third wavelength light and performing crosslinking reaction with the quantum dots, thereby forming the crosslinked quantum dot light-emitting layer 303. For example, the first wavelength light absorbing molecules in the quantum dot light-emitting layer 303 and the first crosslinking agent in the hole transport layer 102 may be the same.

In some alternative embodiments, the first wavelength light absorbing molecules in the quantum dot light-emitting layer 303 are not bisazide molecules, but molecules comprising monoazide groups. Although these first wavelength light absorbing molecules are different from the first crosslinking agent, they all have the same light absorbing characteristics as the first crosslinking agent, and can absorb first wavelength light. For example, this kind of molecular structure can be half of the structure of bisazide molecular structure. For example, monoazide molecules include, but are not limited to, methyl 4-azido tetrafluorobenzoate shown in Fig. 8, 4-azido tetrafluorobenzoic acid shown in Fig. 9, 4-azido tetrafluorobenzaldehyde shown in Fig. 10, etc. These monoazide molecules containing 4-azido tetrafluorophenyl can be precursor molecules for synthesizing bisazide molecules. In some embodiments, in the monoazide molecule, the para-position group of the azide group N3 can be any one of alkyl, ether, alcohol and halogen.

When the first wavelength light absorbing molecules are monoazide molecules, in the second exposure process, the second crosslinking agent absorbs the second wavelength light in the third wavelength light and performs crosslinking reaction with the quantum dots, while the first wavelength light absorbing molecules absorb the first wavelength light in the third wavelength light and generate nitrogen carbene radicals, and the first wavelength light absorbing molecules are connected to the quantum dot ligands through chemical bonds but do not perform crosslinking reaction with the quantum dot ligands, thus forming the quantum dot light-emitting layer 303. This is beneficial, if the first wavelength light absorbing molecules crosslink with quantum dot ligands, the photoluminescence quantum efficiency (PLQY) of quantum dots may be reduced, which may lead to the problems of insufficient brightness of light-emitting devices. However, using monoazide molecules as first wavelength light absorbing molecules only absorb first wavelength light and generates single nitrogen carbene radicals, and the single nitrogen carbene radicals will not participate in the crosslinking process of quantum dots, thus avoiding the problems of insufficient brightness caused by the crosslinking of first wavelength light absorbing molecules with quantum dot ligands.

In some alternative embodiments, the first wavelength light absorbing molecules in the quantum dot light-emitting layer 303 are not bisazide molecules, but molecules comprising benzophenone groups. Although these first wavelength light absorbing molecules are different from the first crosslinking agent, they all have the same light absorbing characteristics as the first crosslinking agent, and can absorb first wavelength light. For example, benzophenone molecules include, but are not limited to, benzophenone shown in Fig. 11, 4,4' difluorobenzophenone shown in Fig. 12, 4-chlorobenzophenone shown in Fig. 13. In some embodiments, in benzophenone molecules, benzene rings on benzophenone structural units are not connected with electron-donating groups, which comprise but are not limited to nitrogen atom, phosphorus atom, oxygen atom, sulfur atom.

When the first wavelength light absorbing molecules are benzophenone molecules, in the second exposure process, the second crosslinking agent absorbs the second wavelength light and performs crosslinking reaction with the quantum dots, while the first wavelength light absorbing molecules absorb the first wavelength light in the third wavelength light and generate carbon carbene radicals, and the first wavelength light absorbing molecules are connected to the quantum dot ligands through chemical bonds but do not perform crosslinking reaction with the quantum dot ligands, thus forming the quantum dot light-emitting layer 303. This is beneficial, if the first wavelength light absorbing molecules crosslink with quantum dot ligands, the photoluminescence quantum efficiency (PLQY) of quantum dots may be reduced, which may lead to problems such as insufficient brightness of light-emitting devices. However, using benzophenone molecules as the first wavelength light absorbing molecules only absorb the first wavelength light but do not participate in the crosslinking process of quantum dots, thus avoiding the problems of insufficient brightness caused by the crosslinking of the first wavelength light absorbing molecules with quantum dot ligands.

As mentioned above, the crosslinking between the crosslinking agent and the hole transport material can lead to the decrease of the hole mobility of the hole transport layer. Therefore, in other embodiments of the present disclosure, the hole mobility of the hole transport layer is improved by reducing the concentration of the first crosslinking agent in the first mixed solution (the mixed solution of the hole transport material and the first crosslinking agent).

Specifically, for the first mixed solution, the inventors designe the following three concentrations: the concentration ratios of the hole transport material and the first crosslinking agent in the first mixed solution are 8 mg/ml: 0.5 mg/ml, 8 mg/ml: 0.2 mg/ml, and 8 mg/ml: 0.05 mg/ml, respectively. Curing the three first mixed solutions to form three first cured layers. Then, the first exposure process is performed, that is, three kinds of first cured layers are irradiated by a first wavelength light, so that the first crosslinking agent and the hole transport material are crosslinked to form three different hole transport layers. Then quantum dot light-emitting layers are formed above the three hole transport layers respectively to form three different light-emitting devices. For the sake of brevity, the light-emitting device corresponding to the concentration ratio of the hole transport material to the first crosslinking agent being 8 mg/ml: 0.5 mg/ml is called light-emitting device 1, the light-emitting device corresponding to the concentration ratio of the hole transport material to the first crosslinking agent being 8 mg/ml: 0.2 mg/ml is called light-emitting device 2, and the light-emitting device corresponding to the concentration ratio of the hole transport material to the first crosslinking agent being 8 mg/ml: 0.05 mg/ml is called light-emitting device 3.

The current densities of the light-emitting devices 1, 2 and 3 before performing the first exposure process and the light-emitting devices 1, 2 and 3 after performing the first exposure process are tested respectively. The results show that, compared with current densities before the first exposure process, the current density of light-emitting device 1 decreased by about 50 times (from 65mA/cm² to 1.3mA/cm²) after the first exposure process, the current density of light-emitting device 2 decreased by about 15 times (from 33mA/cm² to 2.5mA/cm²) after the first exposure process, and the current density of light-emitting device 3 decreased by about 3 times (from 90mA/cm² to 30 mA/cm²) after the first exposure process. The results show that, firstly, the crosslinking between the first crosslinking agent and the hole transport material does reduce the hole mobility of the hole transport layer. However, the lower the concentration of the first crosslinking agent in the first mixed solution, the less the hole mobility of the hole transport layer will be reduced due to exposure crosslinking, which will have less influence on the reduction of the current density of the light-emitting device.

The inventors further tested the EQE of the light-emitting devices 1, 2, and 3 before performing the first exposure process and the light-emitting devices 1, 2 and 3 after performing the first exposure process, respectively. The results show that, compared with the EQE before the first exposure process, the EQE of light-emitting device 1 decreased by about 30% (from 23% to 16%) after the first exposure process, the EQE of light-emitting device 2 decreased by about 20% (from 15.5% to 12%) after the first exposure process, and the EQE of light-emitting device 3 decreased by about 15% (from 21% to 18%) after the first exposure process. This shows that the lower the concentration of the first crosslinking agent in the first mixed solution, the less the decrease of hole mobility in the hole transport layer caused by exposure crosslinking, and thus the less the influence on the imbalance between electrons and holes in the light-emitting device, and thus the less the EQE decrease of the light-emitting device.

It should be noted that reducing the concentration of the first crosslinking agent in the first mixed solution can be carried out alone or in any combination with the previous embodiments. For example, the first wavelength light blocking layer 104 may not be provided between the hole transport layer 102 and the quantum dot light-emitting layer 103 or the side of the quantum dot light-emitting layer 103 away from the substrate 101, but the concentration of the first crosslinking agent in the first mixed solution may be reduced only when the hole transport layer 102 is prepared, so as to improve the hole mobility of the hole transport layer 102. Alternatively, the hole mobility of the hole transport layer 102 can be improved by only reducing the concentration of the first crosslinking agent in the first mixed solution when preparing the hole transport layer 102 without adding first wavelength light absorbing molecules into the quantum dot light-emitting layer 303. Alternatively, on the basis of the light-emitting devices 100, 200, and 300, the concentration of the first crosslinking agent in the first mixed solution can be reduced when preparing the hole transport layer 102, thereby further improving the hole mobility of the hole transport layer 102.

Fig. 16 shows a structural schematic diagram of a light-emitting device 400 according to an embodiment of the present disclosure. As shown in Fig. 16, the light-emitting device 400 comprises a substrate 101, a hole injection layer 105, a hole transport layer 102, a first wavelength light blocking layer 104, a quantum dot light-emitting layer 103, an electron transport layer 106, and a second electrode 107 which are stacked in sequence. The substrate 101 may be, for example, an anode, and the second electrode 107 may be, for example, a cathode. The light-emitting device 400 is an upright light-emitting device.

In some embodiments, the material of the polymer molecules in the first wavelength light blocking layer 104 is the same as the hole transport material of the hole transport layer 102, and the material of the first wavelength light absorbing molecules in the first wavelength light blocking layer 104 is the same as the material of the first crosslinking agent in the hole transport layer 102. In an example, the material of the substrate 101 is ITO, the material of the hole injection layer 105 is poly (3,4- ethylenedioxythiophene (PEDOT), the hole transport material of the hole transport layer 102 is TFB, the first crosslinking agent of the hole transport layer 102 are bisazide molecules, the polymer molecules of the first wavelength light blocking layer 104 are TFB, and the first wavelength light absorbing molecules in the first wavelength light blocking layer 104 are bisazide molecules, the second crosslinking agent in the quantum dot light-emitting layer 103 is benzophenone crosslinking agent, the material of the electron transport layer 106 is molybdenum oxide, and the material of the second electrode 107 is aluminum. Compared with the light-emitting device without the first wavelength light blocking layer, the current density of the light-emitting device 400 is increased by about 4 times. This is because the first wavelength light blocking layer 104 in the light-emitting device 400 absorbs the first wavelength light transmitted through the quantum dot light-emitting layer 103 in the second exposure process, and prevents the first wavelength light from radiating the hole transport layer 102, thus avoiding further reducing the hole mobility of the hole transport layer 102, thus improving the current density of the light-emitting device 400.

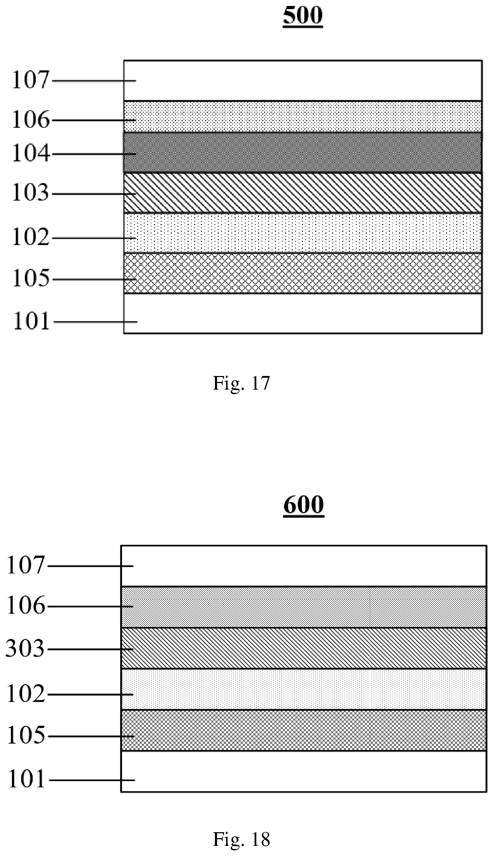

Fig. 17 shows a structural schematic diagram of a light-emitting device 500 according to another embodiment of the present disclosure. As shown in Fig. 17, the light-emitting device 500 comprises a substrate 101, a hole injection layer 105, a hole transport layer 102, a quantum dot light-emitting layer 103, a first wavelength light blocking layer 104, an electron transport layer 106, and a second electrode 107 which are stacked in sequence. The substrate 101 may be, for example, an anode, and the second electrode 107 may be, for example, a cathode. The light-emitting device 500 is an upright light-emitting device.

Fig. 18 shows a structural schematic diagram of a light-emitting device 600 according to another embodiment of the present disclosure. As shown in Fig. 18, the light-emitting device 600 comprises a substrate 101, a hole injection layer 105, a hole transport layer 102, a quantum dot light-emitting layer 303, an electron transport layer 106, and a second electrode 107 which are stacked in sequence. The substrate 101 may be, for example, an anode, and the second electrode 107 may be, for example, a cathode. The light-emitting device 600 is an upright light-emitting device. The structure of the quantum dot light-emitting layer 303 is the same as the structure of the quantum dot light-emitting layer 303 in Fig. 15.

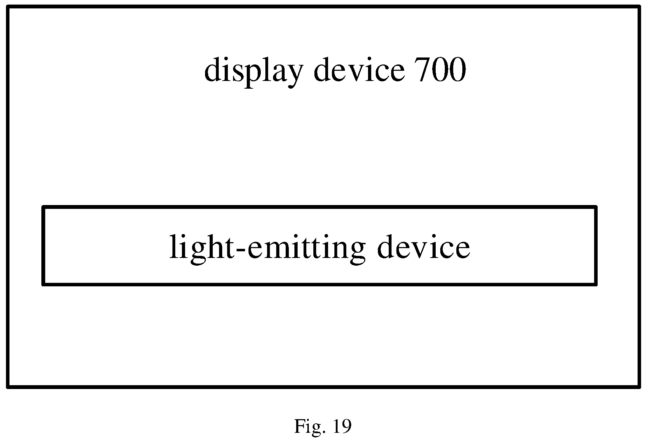

Fig. 19 shows a block diagram of a display device 700 according to an embodiment of the present disclosure. The display device 700 comprises a plurality of sub-pixels, and a light-emitting device is arranged in each sub-pixel, and the light-emitting device may be the light-emitting device described in any of the previous embodiments. At least two of the plurality of light-emitting devices emit light of different colors. For example, some light-emitting devices in the plurality of light-emitting devices comprise red quantum dot light-emitting layers and are used to emit red light; some light-emitting devices in the plurality of light-emitting devices comprise green quantum dot light-emitting layers and are used to emit green light; some light-emitting devices in the plurality of light-emitting devices comprise blue quantum dot light-emitting layers and are used to emit blue light, thereby enabling the display device 700 to realize full-color display. Of course, the display device 700 also comprises other components not shown, for example, it may comprise a driving circuit for providing an electrical signal to the light-emitting device to drive the light-emitting device to emit light. The display device 700 may also comprise structures such as a circuit board and/or an integrate circuit (IC).

The display device 700 may be a mobile phone, a tablet computer, a television, a display, a notebook computer, a digital photo frame, a navigator and other products or components that display based on quantum dots.

The display device 700 may have basically the same technical effect as the light-emitting device described in the previous embodiment, so for the sake of brevity, the description will not be repeated here.

The quantum dots provided by various embodiments of the present disclosure may be any suitable quantum dots, comprising but not limited to any of IIB-VIA quantum dots, IIIA-VA quantum dots, IV A-VIA quantum dots, core-shell quantum dots and ABX₃ perovskite quantum dots. In ABX₃ perovskite quantum dots, A is one or more of CH₃NH₃⁺ (methylamine), NH₂CH=NH₂ (formamidine) and Cs⁺, B is one or two of Pb²⁺ and Sn²⁺, X is one or more of Cl, Br- and I⁻, and ABX₃ perovskite quantum dots comprise CH₃NH₃PbBr₃, CH₃NH₃PbCl₃, CH₃NH₃PbI₃, CsPbBr₃, CsPbCl₃ and CsPbI₃.

Exemplary, the IIB-VIA quantum dots are selected from one or more binary compounds such as CdSe, CdTe, ZnS, ZnSe, ZnTe, ZnO, HgS, HgSe, HgTe, MgSe and MgS; ternary compounds such as CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, MgZnSe, MgZnS or mixtures thereof; and quaternary compounds such as HgZnTeS, CdZnSeS, CdZnSeTe, CdZnSTe, CdHgSeS, CdHgSeTe, CdHgSTe, HgZnSeS, HgZnSeTe, HgZnSTe, or mixtures thereof, but not limited thereto.

Group IIIA-VA quantum dots are selected from binary compounds such as GaN, GaP, GaAs, GaSb, AIN, AlP, AlAs, AlSb, InN, InP, InAs, InSb, or mixtures thereof; ternary compounds such as GaNP, GaNAs, GaNSb, GaPAs, GaPSb, AINP, AlNAs, AlNSb, AlPAs, AlPSb, InNP, InNAs, InNSb, InPAs, InPSb, or mixtures thereof; and quaternary compounds such as GaAlNP, GaAINAs, GaAlNSb, GaAlPAs, GaAlPSb, GalnNP, GalnNAs, GaInNSb, GalnPAs, GalnPSb, InAlNP, InAlNAs, InAlNSb, InAlPAs, InAlPASb, or mixtures thereof, but not limited thereto.

IVA-VIA quantum dots are selected from binary compounds such as SnS, SnSe, SnTe, PbS, PbSe, PbTe, or mixtures thereof; ternary compounds such as SnSeS, SnSeTe, SnSTe, PbSeS, PbSeTe, PbSTe, SnPbSe, SnPbSe, SnPbTe, or mixtures thereof; and quaternary compounds such as SnPbSSe, SnPbSeTe, SnPbSTe, or mixtures thereof, but not limited thereto. IVA-VIA quantum dots are, for example, selected from elementary substance (unitary) semiconductors such as Si, Ge, or mixtures thereof; and binary semiconductor compounds such as SiC, SiGe, and mixtures thereof, but not limited thereto.

Quantum dots with core-shell structure mean that one material is the core material and the other is the shell material. For example, the quantum dot is CdS/ZnS, which means that the core material of the quantum dot is CdS and the shell material is ZnS.

In other embodiments, quantum dots may be other nano-scale materials, such as nanorods, nanosheets. Components of other nano-scale materials may comprise at least one of CdS, CdSe, CdTe, ZnSe, InP, PbS, CuInS₂, ZnO, CsPbCl₃, CsPbBr₃, CsPhI₃, CdS/ZnS, CdSe/ZnS, ZnSe, InP/ZnS, PbS/ZnS, InAs, InGaAs, InGaN, GaN, ZnTe, Si, Ge and C.

For example, the quantum dots may comprise cadmium free quantum dots. Cadmium-free quantum dots are quantum dots that do not comprise cadmium (Cd). Cadmium (Cd) can cause serious environmental/health problems, so non-Cd-based quantum dots can be effectively used.

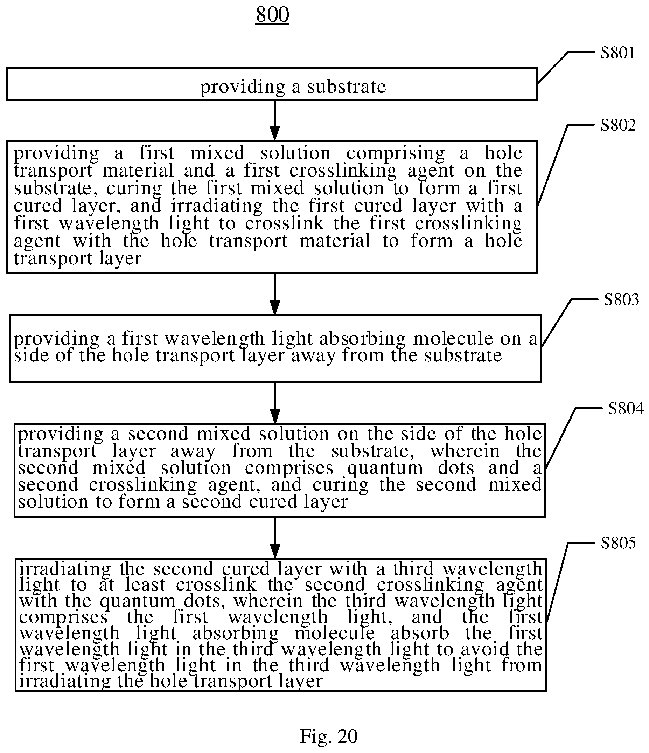

Fig. 20 shows a flowchart of a method 800 of manufacturing a light-emitting device. As shown in Fig. 20, the method 800 comprises the following steps:
S801: providing a substrate. The substrate may be, for example, the anode of a light-emitting device, and the material of the substrate may be any suitable material, such as ITO.
S802: providing a first mixed solution comprising a hole transport material and a first crosslinking agent on the substrate, and curing the first mixed solution to form a first cured layer. A first exposure process is performed, that is, the first cured layer is irradiated by a first wavelength light, so that the first crosslinking agent and the hole transport material are crosslinked to form a hole transport layer.

The first wavelength light may be ultraviolet light, and illustratively, the first wavelength light may be ultraviolet light of 254nm. The hole transport material may be any suitable material, comprising but not limited to TFB, polyTPD, PVK, etc. The first crosslinking agent may be a crosslinking agent molecule such as azide system, diazo system, benzophenone system, etc. The hole transport layer 102 comprises a crosslinked structure generated by crosslinking a hole transport material with a first crosslinking agent. In some embodiments, the hole transport layer 102 is a composite system, and besides the crosslinked structure, the hole transport layer 102 also comprises the remaining first crosslinking agent. Here, the "remaining first crosslinking agent" refers to the excessive first crosslinking agent that does not participate in the crosslinking reaction. In the first mixed solution, the first crosslinking agent may be excessive. After the first exposure crosslinking, all the hole transport materials in the first mixed solution have been crosslinked, and some of the first crosslinking agent will remain without crosslinking.

S803: providing first wavelength light absorbing molecules on a side of the hole transport layer away from the substrate. The first wavelength light absorbing molecules can absorb the first wavelength light.

S804: providing a second mixed solution comprising quantum dots and a second crosslinking agent on the side of the hole transport layer away from the substrate, and curing the second mixed solution to form a second cured layer.

S805: performing the second exposure process, that is, irradiating the second cured layer with the third wavelength light to crosslink at least the second crosslinking agent and the quantum dots, wherein the third wavelength light comprises the first wavelength light, and the first wavelength light absorbing molecules absorb the first wavelength light in the third wavelength light to avoid the first wavelength light from radiating the hole transport layer.

In the method 800, by providing first wavelength light absorbing molecules on the side of the hole transport layer away from the substrate, the first wavelength light absorbing molecules can absorb the first wavelength light, so that when the quantum dot light-emitting layer above the hole transport layer is exposed and crosslinked, even though the third wavelength light will pass through the quantum dot light-emitting layer, the first wavelength light in the third wavelength light will not reach the hole transport layer, but will be absorbed by the first wavelength light absorbing molecules before reaching the hole transport layer. In this way, the hole transport layer will not be further crosslinked, thus avoiding the decrease of hole mobility of the hole transport layer and avoiding the influence on the efficiency of the light-emitting device.

When the light-emitting device is the light-emitting device 100 shown in Fig. 5, step S803 may comprise the following sub-steps: providing a third mixed solution comprising polymer molecules and first wavelength light absorbing molecules on the side of the hole transport layer 102 away from the substrate 101, applying the third mixed solution on the hole transport layer 102, and forming the first wavelength light blocking layer 104 by spin coating or blade coating. For example, the concentration ratio of polymer molecules to first wavelength light absorbing molecules in the third mixed solution may be 0.8 ~ 0.5 mg/ml: 0.5 mg/ml, for example, the concentration ratio of polymer molecules to first wavelength light absorbing molecules may be 0.8 mg/ml: 0.5 mg/ml, 0.7 mg/ml: 0.5 mg/ml, 0.6 mg/ml: 0.5 mg/ml, 0.5 mg/ml: 0.5 mg/ml. The solvent in the third mixed solution may be any suitable solvent, such as chlorobenzene solvent.

Polymer molecules may be the same as hole transport materials, such as TFB, PVK, Poly-TPD, or may be different from hole transport materials, such as other polymer molecules that are easy to form films. The first wavelength light absorbing molecules may be the same as or different from the first crosslinking agent. Illustratively, the first wavelength light absorbing molecules may be bisazide molecules shown in Fig. 6 or Fig. 7, or monoazide molecules shown in Figs. 8 to 10, or benzophenone molecules shown in Figs. 11 to 13, or other appropriate molecules. In some embodiments, the material of the polymer molecules in the first wavelength light blocking layer 104 is the same as the hole transport material of the hole transport layer 102, and the material of the first wavelength light absorbing molecules in the first wavelength light blocking layer 104 is the same as the material of the first crosslinking agent in the hole transport layer 102. Illustratively, the thickness of the first wavelength light blocking layer 104 is less than or equal to 2nm, for example, 0.5nm, 1nm, 2nm. The first wavelength light blocking layer 104 and the first crosslinking agent can absorb ultraviolet light in the same wavelength band, and both of them can absorb the first wavelength light (ultraviolet light of 254 nm).

When the first wavelength light absorbing molecules in the first wavelength light blocking layer 104 are bisazide molecules shown in Fig. 6 or Fig. 7, step S805 may comprise the following sub-steps: irradiating the second cured layer with the third wavelength light, and the second crosslinking agent absorbing the second wavelength light in the third wavelength light and performing crosslinking reaction with the quantum dots to form the quantum dot light-emitting layer 103; the first wavelength light absorbing molecules absorbing the first wavelength light in the third wavelength light and crosslinking with the polymer molecules to form the crosslinked first wavelength light blocking layer 104. In some cases, step S805 may further comprise the following sub-steps: irradiating the second cured layer with the third wavelength light, and the second crosslinking agent absorbing the second wavelength light in the third wavelength light and performing crosslinking reaction with the quantum dots to form the quantum dot light-emitting layer 103; the first wavelength light absorbing molecules absorbing the first wavelength light in the third wavelength light and crosslinking with the polymer molecules, while the polymer molecules crosslinking with the quantum dot ligands through the bisazide groups.

In some embodiments, in addition to the crosslinked structure, the first wavelength light blocking layer 104 also comprises the remaining first wavelength light absorbing molecules, that is, the first wavelength light blocking layer 104 is a composite film layer. Similarly, the term "remaining first wavelength light absorbing molecules" here refers to excessive first wavelength light absorbing molecules that have not participated in the crosslinking reaction. In order to ensure that the thin first wavelength light blocking layer 104 can fully absorb the first wavelength light in the second exposure process, the first wavelength light absorbing molecules in the first wavelength light blocking layer 104 are usually excessive. After the second exposure process, all polymer molecules have been crosslinked, while some first wavelength light absorbing molecules remain without crosslinking.

In some embodiments, the polymer molecule is TFB, and the first wavelength light absorbing molecule is a bisazide molecule. When preparing a third mixed solution comprising polymer molecules and first wavelength light absorbing molecules, in some examples, the concentration ratio of the polymer molecule solution to the first wavelength light absorbing molecule solution may be 0.8 mg/ml: 0.5 mg/ml, and the thickness of the formed first wavelength light blocking layer 104 is about 2nm. In still other examples, the concentration ratio of the polymer molecule solution to the first wavelength light absorbing molecule solution may be 0.5 mg/ml: 0.5 mg/ml, and the thickness of the formed first wavelength light blocking layer 104 is about 1nm. In still other examples, when the thickness of the first wavelength light blocking layer 104 is required to be less than 1nm, the concentration of the first wavelength light absorbing molecules in the third mixed solution is not less than the concentration of the first crosslinking agent in the first mixed solution (comprising the hole transport material and the first crosslinking agent).

When the first wavelength light absorbing molecules in the first wavelength light blocking layer 104 are monoazide molecules shown in Figs. 8 to 10, step S805 may comprise the following sub-steps:
irradiating the second cured layer with the third wavelength light, and the second crosslinking agent absorbing the second wavelength light in the third wavelength light and crosslinking with the quantum dots to form the quantum dot light-emitting layer 103. At the same time, the first wavelength light absorbing molecules in the first wavelength light blocking layer 104 absorb the first wavelength light in the third wavelength light to generate nitrogen carbene radicals. In some cases, the first wavelength light absorbing molecules are connected to the polymer molecules by chemical bonds, but they will not crosslink with the polymer molecules, that is, they will not change the polymer molecules from linear molecules to three-dimensional network structures, and the polymer molecules are uncrosslinked. Or in other cases, the first wavelength light absorbing molecules are connected with the quantum dot ligand at the interface between the first wavelength light blocking layer 104 and the quantum dot light-emitting layer 103 through chemical bonds, but will not crosslink with the quantum dot ligand.

When the first wavelength light absorbing molecules in the first wavelength light blocking layer 104 are benzophenone molecules shown in Figs. 11 to 13, step S805 may comprise the following sub-steps:
irradiating the second cured layer with the third wavelength light, and the second crosslinking agent absorbing the second wavelength light in the third wavelength light and crosslinking with the quantum dots to form the quantum dot light-emitting layer 103. At the same time, the first wavelength light absorbing molecules in the first wavelength light blocking layer 104 absorb the first wavelength light in the third wavelength light to generate carbon carbene radicals. In some cases, the first wavelength light absorbing molecules are connected to the polymer molecules by chemical bonds, but they will not crosslink with the polymer molecules, that is, they will not change the polymer molecules from linear molecules to three-dimensional network structures, and the polymer molecules are uncrosslinked. Or in other cases, the first wavelength light absorbing molecules are connected with the quantum dot ligands at the interface between the first wavelength light blocking layer 104 and the quantum dot light-emitting layer 103 through chemical bonds, but will not crosslink with the quantum dot ligands.

It is beneficial that the first wavelength light absorbing molecules in the first wavelength light blocking layer 104 do not crosslink with the quantum dot ligands, if the first wavelength light absorbing molecules crosslink with quantum dot ligands, the photoluminescence quantum efficiency (PLQY) of quantum dots may be reduced, which may lead to the problems of insufficient brightness of light-emitting devices. However, using monoazide molecules or benzophenone molecules as first wavelength light absorbing molecules only absorb first wavelength light and generates single nitrogen carbene radicals, and the single nitrogen carbene radicals will not participate in the crosslinking process of quantum dots, thus avoiding the problems of insufficient brightness caused by the crosslinking of first wavelength light absorbing molecules with quantum dot ligands.

When the light-emitting device is the light-emitting device 300 shown in Fig. 15, steps S803 and S804 may comprise the following sub-steps: providing a second mixed solution on the side of the hole transport layer 102 away from the substrate 101, wherein the second mixed solution comprises quantum dots, a second crosslinking agent, and first wavelength light absorbing molecules, and curing the second mixed solution to form a second cured layer. In some embodiments, the concentration of first wavelength light absorbing molecules in the second mixed solution is 0.2-0.5mg/ml, such as 0.2mg/ml, 0.3mg/ml, 0.4mg/ml, 0.5 mg/ml. For example, in the second mixed solution, the concentration ratio of first wavelength light absorbing molecules to quantum dots may be 0.2 ~ 0.5 mg/ml: 20 mg/ml.

When the light-emitting device is the light-emitting device 300 shown in Fig. 15, step S805 may comprise the following sub-steps: performing a second exposure process on the second cured layer, that is, irradiating the second cured layer with the third wavelength light. The third wavelength light comprises not only the second wavelength light (for example, 365nm) that can crosslink quantum dots, but also the first wavelength light (for example, 254nm, 0.047mW/cm²) and other wavebands light (for example, 405nm, 5mW/cm²). Under the radiation of the third wavelength light, the second crosslinking agent absorbs the second wavelength light in the third wavelength light and performs crosslinking reaction with the quantum dots. The first wavelength light absorbing molecules absorb the first wavelength light in the third wavelength light. Depending on the material type of the first wavelength light absorbing molecules, the first wavelength light absorbing molecules may or may not crosslink with the quantum dots.

When the first wavelength light absorbing molecules in the quantum dot light-emitting layer 303 are bisazide molecules shown in Fig. 6 or Fig. 7, step S805 may comprise the following sub-steps: irradiating the second cured layer with the third wavelength light, and the second crosslinking agent absorbing the second wavelength light and performing crosslinking reaction with the quantum dots, while the first wavelength light absorbing molecules absorbing the third wavelength light and performing crosslinking reaction with the quantum dots, thereby forming the crosslinked quantum dot light-emitting layer 303. Illustratively, the first wavelength light absorbing molecules in the quantum dot light-emitting layer 303 and the first crosslinking agent in the hole transport layer 102 may be the same.

When the first wavelength light absorbing molecules in the quantum dot light-emitting layer 303 are monoazide molecules shown in Figs. 8 to 10 or benzophenone molecules shown in Figs. **11** to 13, step S805 may comprise the following sub-steps: irradiating the second cured layer with the third wavelength light, the second crosslinking agent absorbing the second wavelength light in the third wavelength light and performing crosslinking reaction with the quantum dots, the first wavelength light absorbing molecules are connected to the quantum dot ligands through chemical bonds but do not perform crosslinking reaction with the quantum dot ligands, thus forming the quantum dot light-emitting layer 303.

Although these first wavelength light absorbing molecules are different from the first crosslinking agent, they have the same light absorbing characteristics as the first crosslinking agent, and both can absorb first wavelength light. When the first wavelength light absorbing molecules in the quantum dot light-emitting layer 303 are monoazide molecules shown in Figs. 8 to 10, in some embodiments, the para-position group of the azide group N3 can be any one of alkyl, ether, alcohol and halogen. When the first wavelength light absorbing molecules in the quantum dot light-emitting layer 303 are benzophenone molecules shown in Figs. 11 to 13, in some embodiments, the benzene ring on the benzophenone structural unit is not connected with the electron-donating group, and the electron-donating group comprises but is not limited to nitrogen atom, phosphorus atom, oxygen atom, sulfur atom.

It is beneficial that the first wavelength light absorbing molecules in the quantum dot light-emitting layer 303 do not crosslink with the quantum dot ligands, if the first wavelength light absorbing molecules crosslink with quantum dot ligands, the photoluminescence quantum efficiency (PLQY) of quantum dots may be reduced, which may lead to the problems of insufficient brightness of light-emitting devices. However, using monoazide molecules or benzophenone molecules as first wavelength light absorbing molecules only absorb first wavelength light and generates single nitrogen carbene radicals, and the single nitrogen carbene radicals will not participate in the crosslinking process of quantum dots, thus avoiding the problems of insufficient brightness caused by the crosslinking of first wavelength light absorbing molecules with quantum dot ligands.

In the method 800, a first wavelength light blocking layer 104 comprising first wavelength light absorbing molecules is formed between the hole transport layer 102 and the quantum dot light-emitting layer 103, or a first wavelength light blocking layer 104 comprising first wavelength light absorbing molecules is formed on the side of the quantum dot light-emitting layer 103 away from the substrate 101, or first wavelength light absorbing molecules are added in the quantum dot light-emitting layer 303. The first wavelength light absorbing molecules may be various appropriate types of molecules, such as bisazide molecules, monoazide molecules, benzophenone molecules. When the quantum dot light-emitting material is exposed, even though the first wavelength light in the third wavelength light will pass through the quantum dot light-emitting layer, the first wavelength light will not reach the hole transport layer 102, but will be absorbed by the first wavelength light absorbing molecules before reaching the hole transport layer 102. In this way, the hole transport layer 102 will not be further crosslinked, so that the decrease of hole mobility of the hole transport layer 102 can be avoided and the efficiency of the light-emitting device can be improved.

In other embodiments, when preparing the first mixed solution (mixed solution of the hole transport material and the first crosslinking agent), the hole mobility of the hole transport layer is improved by reducing the concentration of the first crosslinking agent in the first mixed solution.

Specifically, the concentration ratios of the hole transport material to the first crosslinking agent in the first mixed solution may be 8 mg/ml: 0.5 mg/ml, 8 mg/ml: 0.2 mg/ml, and 8 mg/ml: 0.05 mg/ml, respectively. Curing the three first mixed solutions to form three first cured layers. Then, the first exposure process is performed, that is, three first cured layers are irradiated by the first wavelength light, so that the first crosslinking agent and the hole transport material are crosslinked to form three different hole transport layers. Then quantum dot light-emitting layers are formed above the three hole transport layers respectively to form three different light-emitting devices. For the sake of brevity, the light-emitting device corresponding to the concentration ratio of the hole transport material to the first crosslinking agent being 8 mg/ml: 0.5 mg/ml is called light-emitting device 1, the light-emitting device corresponding to the concentration ratio of the hole transport material to the first crosslinking agent being 8 mg/ml: 0.2 mg/ml is called light-emitting device 2, and the light-emitting device corresponding to the concentration ratio of the hole transport material to the first crosslinking agent being 8 mg/ml: 0.05 mg/ml is called light-emitting device 3.

The current densities of the light-emitting devices 1, 2 and 3 before performing the first exposure process and the light-emitting devices 1, 2 and 3 after performing the first exposure process are tested respectively. The results show that, compared with current densities before the first exposure process, the current density of light-emitting device 1 decreased by about 50 times (from 65mA/cm² to 1.3mA/cm²) after the first exposure process, the current density of light-emitting device 2 decreased by about 15 times (from 33mA/cm² to 2.5mA/cm²) after the first exposure process, and the current density of light-emitting device 3 decreased by about 3 times (from 90mA/cm² to 30 mA/cm²) after the first exposure process. The results show that, firstly, the crosslinking between the first crosslinking agent and the hole transport material does reduce the hole mobility of the hole transport layer. However, the lower the concentration of the first crosslinking agent in the first mixed solution, the less the hole mobility of the hole transport layer will be reduced due to exposure crosslinking, which will have less influence on the reduction of the current density of the light-emitting device.

The inventors further tested the EQE of the light-emitting devices 1, 2, and 3 before performing the first exposure process and the light-emitting devices 1, 2 and 3 after performing the first exposure process, respectively. The results show that, compared with the EQE before the first exposure process, the EQE of light-emitting device 1 decreased by about 30% (from 23% to 16%) after the first exposure process, the EQE of light-emitting device 2 decreased by about 20% (from 15.5% to 12%) after the first exposure process, and the EQE of light-emitting device 3 decreased by about 15% (from 21% to 18%) after the first exposure process. This shows that the lower the concentration of the first crosslinking agent in the first mixed solution, the less the decrease of hole mobility in the hole transport layer caused by exposure crosslinking, and thus the less the influence on the imbalance between electrons and holes in the light-emitting device, and thus the less the EQE decrease of the light-emitting device.

It should be noted that reducing the concentration of the first crosslinking agent in the first mixed solution can be carried out alone or in any combination with the previous embodiments. For example, the first wavelength light blocking layer 104 may not be provided between the hole transport layer 102 and the quantum dot light-emitting layer 103 or the side of the quantum dot light-emitting layer 103 away from the substrate 101, but the concentration of the first crosslinking agent in the first mixed solution may be reduced only when the hole transport layer 102 is prepared, so as to improve the hole mobility of the hole transport layer 102. Alternatively, the hole mobility of the hole transport layer 102 can be improved by only reducing the concentration of the first crosslinking agent in the first mixed solution when preparing the hole transport layer 102 without adding first wavelength light absorbing molecules into the quantum dot light-emitting layer 303. Alternatively, on the basis of the light-emitting devices 100, 200, and 300, the concentration of the first crosslinking agent in the first mixed solution can be reduced when preparing the hole transport layer 102, thereby further improving the hole mobility of the hole transport layer 102.

Other technical effects of the method 800 can refer to the technical effects of the light-emitting device described in the previous embodiments, and are not repeated here for brevity.

It will be understood that although the terms first, second, third, etc. may be used herein to describe various elements, compositions, regions, layers and/or portions, these elements, compositions, regions, layers and/or portions should not be limited by these terms. These terms are only used to distinguish an element, composition, region, layer or portion from another element, composition, region, layer or portion. Thus, a first element, composition, region, layer or portion discussed above could be termed a second element, composition, region, layer or portion without departing from the teachings of the present disclosure.

Spatially relative terms such as "row", "column", "below", "above", "left", "right", etc. may be used herein for ease of description to describe factors such as the relationship of an element or feature to another element(s) or feature(s) illustrated in the figures. It will be understood that these spatially relative terms are intended to encompass different orientations of the device in use or operation in addition to the orientation depicted in the figures. For example, if the device in the figures is turned over, elements described as "below" other elements or features would then be oriented "above" other elements or features. Thus, the exemplary term "below" can encompass both an orientation of above and below. The device may be otherwise oriented (rotated 90 degrees or at other orientations) and the spatially relative descriptors used herein are interpreted accordingly. In addition, it will also be understood that when a layer is referred to as being "between" two layers, it can be the only layer between the two layers, or one or more intervening layers may also be present.

The terminology used herein is for the purpose of describing particular embodiments only and is not intended to limit the present disclosure. As used herein, the singular forms "a," "an," and "the" are intended to comprise the plural forms as well, unless the context clearly dictates otherwise. It will be further understood that the terms "comprise" and/or "include" when used in this specification designate the presence of stated features, integers, steps, operations, elements and/or parts, but do not exclude the presence or addition of one or more other features, integers, steps, operations, elements, compositions and/or groups thereof. As used herein, the term "and/or" comprises any and all combinations of one or more of the associated listed items. In the description of this specification, description with reference to the terms "an embodiment," "another embodiment," etc. means that a particular feature, structure, material, or characteristic described in connection with the embodiment is included in at least one embodiment of the present disclosure. In this specification, schematic representations of the above terms are not necessarily directed to the same embodiment or example. Furthermore, the particular features, structures, materials or characteristics described may be combined in any suitable manner in any one or more embodiments or examples. Furthermore, those skilled in the art may combine the different embodiments or examples as well as the features of the different embodiments or examples described in this specification without conflicting each other.

It will be understood that when an element or layer is referred to as being "on", "connected to", "coupled to", or "adjacent to" another element or layer, it may be directly on, directly connected to, directly coupled to, or directly adjacent to another element or layer, or intervening elements or layers may be present. In contrast, when an element is referred to as being "directly on", "directly connected to", "directly coupled to", "directly adjacent to" another element or layer, with no intervening elements or layers present. However, in no case should "on" or "directly on" be interpreted as requiring a layer to completely cover the layer below.

Embodiments of the disclosure are described herein with reference to schematic illustrations (and intermediate structures) of idealized embodiments of the disclosure. As such, variations to the shapes of the illustrations are to be expected, e.g., as a result of manufacturing techniques and/or tolerances. Accordingly, embodiments of the present disclosure should not be construed as limited to the particular shapes of the regions illustrated herein, but are to comprise deviations in shapes due, for example, to manufacturing. Thus, the regions illustrated in the figures are schematic in nature and their shapes are not intended to illustrate the actual shape of a region of a device and are not intended to limit the scope of the present disclosure.

Unless otherwise defined, all terms (comprising technical and scientific terms) used herein have the same meaning as commonly understood by one of ordinary skill in the art to which this disclosure belongs. It will be further understood that terms such as those defined in commonly used dictionaries should be construed to have meanings consistent with their meanings in the relevant art and/or the context of this specification, and will not be idealized or overly interpreted in a formal sense, unless expressly defined as such herein.

As will be appreciated by those skilled in the art, although the steps of the methods of the present disclosure are depicted in a particular order in the figures, this does not require or imply that the steps must be performed in that particular order, unless the context clearly dictates otherwise. Additionally or alternatively, multiple steps may be combined into one step for execution, and/or one step may be decomposed into multiple steps for execution. Furthermore, other method steps may be inserted between the steps. The inserted steps may represent such as improvements of a method described herein, or may be unrelated to the method. Also, a given step may not be fully complete before the next step starts.

As used herein, "about", "roughly" or "approximately" includes the stated value and an average value within an acceptable deviation range of a specific value, which is determined by a person of ordinary skill in the art in consideration of the measurement in question and the error (i.e., the limitations of the measurement system) associated with the measurement of a specific quantity.

The above descriptions are merely specific embodiments of the present disclosure, but the protection scope of the present disclosure is not limited thereto. Any changes or substitutions that those skilled in the art can easily think of within the technical scope disclosed by the present disclosure, should be comprised within the protection scope of the present disclosure. Therefore, the protection scope of the present disclosure should be based on the protection scope of the claims.

## Claims

1. A light-emitting device, comprising:
a substrate;
a hole transport layer on the substrate;
a quantum dot light-emitting layer on a side of the hole transport layer away from the substrate; and
a first wavelength light absorbing molecule on a side of the hole transport layer away from the substrate,
wherein the first wavelength light absorbing molecule is configured to absorb a first wavelength light capable of causing the hole transport layer to undergo a crosslinking reaction.

2. The light-emitting device according to claim 1, further comprising a first wavelength light blocking layer, wherein the first wavelength light blocking layer is between the hole transport layer and the quantum dot light-emitting layer or on a side of the quantum dot light-emitting layer away from the hole transport layer, and the first wavelength light blocking layer comprises the first wavelength light absorbing molecule.

3. The light-emitting device according to claim 2, wherein the first wavelength light blocking layer comprises an azide group or a benzophenone group.

4. The light-emitting device according to claim 3, wherein the first wavelength light absorbing molecule comprises a monoazide group or a bisazide group.

5. The light-emitting device according to any one of claims 2-4, wherein the hole transport layer comprises a crosslinked structure generated by crosslinking a first crosslinking agent with a hole transport material.

6. The light-emitting device according to claim 5, wherein a content ratio of the first wavelength light absorbing molecule in the first wavelength light blocking layer is greater than a content ratio of the first crosslinking agent in the hole transport layer.

7. The light-emitting device according to claim 5, wherein the first wavelength light blocking layer further comprises a polymer molecule.

8. The light-emitting device according to claim 7, wherein the first wavelength light absorbing molecules comprise a bisazide group, and the first wavelength light blocking layer comprises a crosslinked structure generated by crosslinking the first wavelength light absorbing molecule with the polymer molecule.

9. The light-emitting device according to claim 8, wherein the first wavelength light blocking layer further comprises a remaining first wavelength light absorbing molecule.

10. The light-emitting device according to claim 8 or claim 9, wherein the quantum dot light-emitting layer comprises a plurality of quantum dots, at least some of the plurality of quantum dots comprise quantum dot bodies and ligands coordinated on the quantum dot bodies, and the polymer molecule is also crosslinked with at least some ligands through the bisazide group.

11. The light-emitting device according to claim 7, wherein a material of the polymer molecule is same as the hole transport material.

12. The light-emitting device according to any one of claims 5-11, wherein the hole transport layer further comprises a remaining first crosslinking agent.

13. The light-emitting device according to claim 7, wherein the first wavelength light absorbing molecule comprises a benzophenone group or a monoazide group, and the first wavelength light absorbing molecule has a same light absorbing characteristic as the first crosslinking agent.

14. The light-emitting device according to claim 13, wherein in the first wavelength light blocking layer, the first wavelength light absorbing molecule is connected with the polymer molecule through a chemical bond, and the polymer molecule is uncrosslinked.

15. The light-emitting device according to claim 13, wherein the quantum dot light-emitting layer comprises a plurality of quantum dots, at least some of the plurality of quantum dots comprise quantum dot bodies and ligands coordinated on the quantum dot bodies, and the first wavelength light absorbing molecule is connected with at least some ligands through chemical bonds.

16. The light-emitting device according to any one of claims 2-15, wherein a thickness of the first wavelength light blocking layer is less than or equal to 2nm.

17. The light-emitting device according to claim 1, wherein the quantum dot light-emitting layer has a crosslinked structure and comprises quantum dots, a second crosslinking agent, and the first wavelength light absorbing molecule, and the quantum dots are at least crosslinked with the second crosslinking agent.

18. The light-emitting device according to claim 17, wherein the first wavelength light absorbing molecule comprises a bisazide group.

19. The light-emitting device according to claim 17, wherein the first wavelength light absorbing molecule comprises a benzophenone group or a monoazide group.

20. The light-emitting device according to claim 19, wherein
the first wavelength light absorbing molecule comprises a monoazide group, and a para group of the azide group comprises any one of alkyl, ether, alcohol and halogen; or
the first wavelength light absorbing molecule comprises a benzophenone group, and a benzene ring on the benzophenone group is not connected with an electron-donating group.

21. The light-emitting device according to any one of claims 2-16, further comprising:
a hole injection layer between the substrate and the hole transport layer;
an electron transport layer at a side of the quantum dot light-emitting layer away from the substrate; and
a second electrode at a side of the electron transport layer away from the substrate,
wherein the substrate is a first electrode.

22. The light-emitting device according to claim 21, wherein the first wavelength light blocking layer is between the hole transport layer and the quantum dot light-emitting layer, the hole transport layer comprises a crosslinked structure generated by crosslinking a first crosslinking agent with a hole transport material, the first wavelength light blocking layer further comprises a polymer molecule, a material of the polymer molecule is same as the hole transport material, a material of the first wavelength light absorbing molecule is same as a material of the first crosslinking agent, the first wavelength light blocking layer comprises a crosslinked structure generated by crosslinking the first wavelength light absorbing molecule with the polymer molecule, and the quantum dot light-emitting layer comprises a crosslinked structure generated by crosslinking the second crosslinking agent with quantum dots.

23. A display device comprising a plurality of light-emitting devices according to any one of claims 1-22.

24. A method of manufacturing a light-emitting device, comprising:
providing a substrate;
providing a first mixed solution comprising a hole transport material and a first crosslinking agent on the substrate, curing the first mixed solution to form a first cured layer, and irradiating the first cured layer with a first wavelength light to crosslink the first crosslinking agent with the hole transport material to form a hole transport layer;
providing a first wavelength light absorbing molecule on a side of the hole transport layer away from the substrate;
providing a second mixed solution on the side of the hole transport layer away from the substrate, wherein the second mixed solution comprises quantum dots and a second crosslinking agent, and curing the second mixed solution to form a second cured layer; and
irradiating the second cured layer with a third wavelength light to at least crosslink the second crosslinking agent with the quantum dots, wherein the third wavelength light comprises the first wavelength light, and the first wavelength light absorbing molecule absorb the first wavelength light in the third wavelength light to avoid the first wavelength light in the third wavelength light from irradiating the hole transport layer.

25. The method according to claim 24, wherein providing the first wavelength light absorbing molecule on the side of the hole transport layer away from the substrate comprises:
providing a third mixed solution comprising a polymer molecule and the first wavelength light absorbing molecule on the side of the hole transport layer away from the substrate, and applying the third mixed solution on the hole transport layer to form a first wavelength light blocking layer.

26. The method according to claim 25, wherein the first wavelength light absorbing molecule comprises a bisazide group, and the third wavelength light further comprises a second wavelength light,
wherein irradiating the second cured layer with the third wavelength light to at least crosslink the second crosslinking agent with the quantum dots comprises: the second crosslinking agent absorbing the second wavelength light in the third wavelength light and crosslinking with the quantum dots to form a quantum dot light-emitting layer, and the first wavelength light absorbing molecule absorbing the first wavelength light in the third wavelength light and crosslinking with the polymer molecule.

27. The method according to claim 26, wherein the quantum dots comprise quantum dot bodies and ligands coordinated on the quantum dot bodies,
wherein irradiating the second cured layer with the third wavelength light to at least crosslink the second crosslinking agent with the quantum dots further comprises: under the irradiation of the first wavelength light in the third wavelength light, the polymer molecule also crosslinking with the ligands through the bisazide group.

28. The method according to claim 25, wherein the first wavelength light absorbing molecule comprises a monoazide group or a benzophenone group, the quantum dots comprise quantum dot bodies and ligands coordinated on the quantum dot bodies, and the third wavelength light further comprises a second wavelength light,
wherein irradiating the second cured layer with the third wavelength light to at least crosslink the second crosslinking agent with the quantum dots comprises:
the second crosslinking agent absorbing the second wavelength light in the third wavelength light and crosslinking with the quantum dots to form a quantum dot light-emitting layer, and the first wavelength light absorbing molecule absorbing the first wavelength light in the third wavelength light and connecting with the polymer molecule through a chemical bond; or
the second crosslinking agent absorbing the second wavelength light in the third wavelength light and crosslinking with the quantum dots to form a quantum dot light-emitting layer, and the first wavelength light absorbing molecule absorbing the first wavelength light in the third wavelength light and connecting with the ligands through a chemical bond.

29. The method according to claim 24, wherein providing the first wavelength light absorbing molecule at the side of the hole transport layer away from the substrate and providing the second mixed solution at the side of the hole transport layer away from the substrate comprises:
providing the second mixed solution on the side of the hole transport layer away from the substrate, wherein the second mixed solution comprises the quantum dots, the second crosslinking agent and the first wavelength light absorbing molecule, and curing the second mixed solution to form the second cured layer.

30. The method according to claim 29, wherein the first wavelength light absorbing molecule comprises a bisazide group, and the third wavelength light further comprises a second wavelength light,
wherein irradiating the second cured layer with the third wavelength light to at least crosslink the second crosslinking agent with the quantum dots comprises: the second crosslinking agent absorbing the second wavelength light in the third wavelength light and crosslinking with the quantum dots, and the first wavelength light absorbing molecule absorbing the first wavelength light in the third wavelength and crosslinking with the quantum dots to form a quantum dot light-emitting layer.

31. The method according to claim 29, wherein the first wavelength light absorbing molecule comprises a monoazide group or a benzophenone group, the quantum dots comprise quantum dot bodies and ligands coordinated on the quantum dot bodies, and the third wavelength light further comprises a second wavelength light,
wherein irradiating the second cured layer with the third wavelength light to at least crosslink the second crosslinking agent with the quantum dots comprises: the second crosslinking agent absorbing the second wavelength light in the third wavelength light and crosslinking with the quantum dots to form a quantum dot light-emitting layer, and the first wavelength light absorbing molecule absorbing the first wavelength light in the third wavelength light and connecting with the ligands through a chemical bond.

32. The method according to any one of claims 24-31, wherein the concentration ratio of the hole transport material and the first crosslinking agent in the first mixed solution is 8 mg/ml: 0.05-0.5 mg/ml..
